(19) Europäisches Patentamt / European Patent Office / Office européen des brevets

(11) **EP 4 331 734 B1**

(12) **EUROPEAN PATENT SPECIFICATION**

(45) Date of publication and mention
of the grant of the patent:
**25.06.2025 Bulletin 2025/26**

(51) International Patent Classification (IPC):
**B06B 1/06** $^{(2006.01)}$      **G01H 11/08** $^{(2006.01)}$
**H10N 30/30** $^{(2023.01)}$      **H10N 30/20** $^{(2023.01)}$

(21) Application number: **23190778.3**

(22) Date of filing: **10.08.2023**

(52) Cooperative Patent Classification (CPC):
**B06B 1/0622; G01H 11/08; H10N 30/2047;
H10N 30/308**

(54) **MEMS ULTRASONIC TRANSDUCER DEVICE AND MANUFACTURING PROCESS THEREOF**

MEMS-ULTRASCHALLWANDLERVORRICHTUNG UND HERSTELLUNGSVERFAHREN DAFÜR

DISPOSITIF TRANSDUCTEUR ULTRASONORE MEMS ET SON PROCÉDÉ DE FABRICATION

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **05.09.2022 IT 202200018153**

(43) Date of publication of application:
**06.03.2024 Bulletin 2024/10**

(73) Proprietor: **STMicroelectronics S.r.l.
20864 Agrate Brianza (MB) (IT)**

(72) Inventor: **FONCELLINO, Francesco
81022 CASAGIOVE (CE) (IT)**

(74) Representative: **Studio Torta S.p.A.
Via Viotti, 9
10121 Torino (IT)**

(56) References cited:
**US-A1- 2017 095 837      US-A1- 2018 153 512
US-A1- 2020 156 114**

**Description**

The present invention relates to a MEMS ultrasonic transducer, MUT, device. Furthermore, it relates to a manufacturing process and a control method of the MUT device. In particular, the MUT device is frequency-modulable and, in use, emits and/or receives acoustic waves with a frequency depending on the emission direction.

As known, proximity sensors may be provided by time-of-flight sensors. In particular, the time-of-flight sensors may be ultrasonic transducers, for example made using MEMS ("Micro Electro-Mechanical Systems") technology. A known class of MEMS ultrasonic transducers uses piezoelectric technology for the emission and detection of acoustic waves, as better described below.

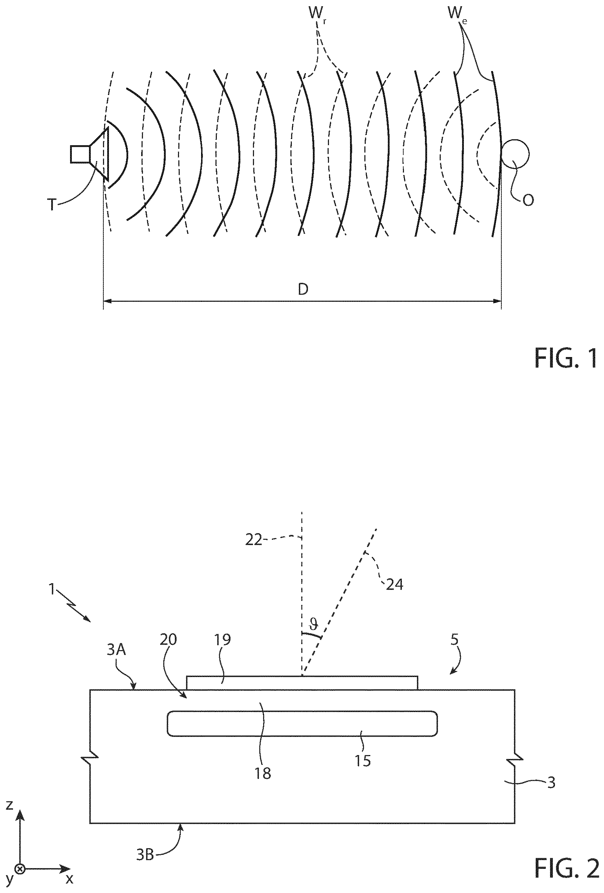

In use, ultrasonic transducers are immersed in a fluid (generally with low density, e.g. air) and are controlled to generate and detect ultrasonic acoustic waves (e.g., with a frequency comprised between 20 kHz and 500 MHz, for example equal to 2 or 3 MHz). In detail, as exemplarily shown in Figure 1, the ultrasonic transducer T generates an ultrasonic wave (or emitted wave, indicated in Figure 1 with the reference $W_e$) which, in the presence of objects O placed along the propagation direction of the acoustic wave, is reflected forming an ultrasonic echo (or reflected wave, indicated in Figure 1 with the reference $W_r$) detectable through the same ultrasonic transducer T; the time distance between the emission of the emitted wave $W_e$ and the reception of the reflected wave $W_r$ is indicative of a relative distance D between the ultrasonic transducer T and the detected object O. Consequently, by measuring the time-of-flight it is possible to have information about the object O to be detected. In greater detail, the ultrasonic transducer T comprises a membrane which, for example by piezoelectricity, is controllable to oscillate in order to generate the emitted wave $W_e$. This membrane is also configured to oscillate when the reflected wave $W_r$ impinges on the ultrasonic transducer T; this allows therefore the reflected wave $W_r$ to be detected, for example by piezoelectricity. In this case, the ultrasonic transducer T operates both as an emitter and as a receiver, at alternating times; nevertheless, it is similarly possible to have a first ultrasonic transducer T which operates as an emitter and a second ultrasonic transducer T which operates as a receiver, and which is arranged so as to detect the reflected wave $W_r$ caused by the emitted wave $W_e$ generated by the first ultrasonic transducer T.

Figure 2 schematically shows an ultrasonic transducer device 1 of a known type and made using MEMS technology, therefore hereinafter also referred to as MUT ("Micromachined Ultrasonic Transducer") device.

For example, the MUT device 1 is integrated in a die comprising a semiconductor body 3 of semiconductor material, such as silicon, for example monolithic, having a first and a second main face 3A, 3B.

The MUT device 1 comprises a MEMS ultrasonic transducer element (or MUT element) 5 extending into the semiconductor body 3.

The MUT element 5 comprises a first buried chamber 15, arranged in proximity to the first main face 3A of the semiconductor body 3 and at a distance from the first main face 3A. The portion of the semiconductor body 3 present between the first chamber 15 and the first main face 3A of the semiconductor body 3 forms a membrane body 18 with a thickness along the Z axis which is uniform.

On the membrane body 18, over the first main face 3A, is arranged a piezoelectric element 19 of a known type which forms, together with the membrane body 18, a membrane 20. The piezoelectric element 19 comprises a layer of piezoelectric material such as PZT, interposed along the Z axis between two electrodes.

In use, the MUT device 1 is surrounded by a propagation means (a fluid such as liquid or gas, in particular air) wherein acoustic waves (in detail, ultrasonic waves) propagate, generated or detected by the MUT device 1, which may operate as an emitter and/or receiver. In particular, when the MUT device 1 operates as an emitter, the piezoelectric element 19 is biased through a drive signal so as to deform elastically to cause a respective elastic deformation of the membrane 20 (i.e. a vibration of the membrane 20). This generates acoustic waves that propagate through the propagation means. On the other hand, when the MUT device 1 operates as a receiver, the acoustic waves that reach the MUT device 1 propagating through the propagation means vibrate the membrane 20 and therefore cause an elastic deformation of the piezoelectric element 19, which generates a consequent electrical signal indicative of the detected acoustic waves.

In detail, both in the emission mode and in the reception mode, the membrane 20 vibrates at a vibration frequency which is about equal to a resonance frequency of the MUT device 1. The resonance frequency depends, in a per se known manner, on factors such as the geometry and materials of the MUT element 5 (e.g., shape and thickness of the membrane 20 and materials of the semiconductor body 3 and of the piezoelectric element 19).

Nevertheless, it is known to electrically control the MUT device 1 in such a way as to electrically modify its resonance frequency, to better adapt it to the required application so as to improve the performances of the MUT device.

For example, this is done in the MUT device 1 by applying to the piezoelectric element 19, in addition to the drive signal, also a modulation signal (e.g., of DC-type), in order to cause a respective and further elastic modulation deformation thereof, which adds to that generated by the piezoelectric element 19 or induced in the latter (in the emission and reception modes, respectively). In particular, the modulation signal is an electrical voltage of the DC-type, for example with a value greater than 0 V and specifically dependent on factors such as the application considered, the structure of the MUT device 1 and the materials wherewith it is made. The effect of the application of the modulation signal is to create an additional stress in the membrane 20 that modifies the mechanical and therefore vibrational properties of the membrane 20, causing a modification (i.e. "tuning") of the resonance frequency.

On the other hand, other known solutions concern the use of one or more further piezoelectric elements on the membrane body 18, arranged side by side with the piezoelectric element 19. These further piezoelectric elements are electrically controlled independently from the piezoelectric element 19 (for example, through the modulation signal previously mentioned) and are used to generate an additional stress in the membrane 20 which modifies the mechanical and therefore vibrational properties of the membrane 20, causing a modification of the resonance frequency.

On the other hand, a further known solution (e.g., prior art document US 2013/0162102 A1) comprises the use of a bimorph structure for the piezoelectric element 19. In this solution, the piezoelectric element 19 comprises a plurality of electrode-PZT-electrode stacks superimposed on each other along the Z axis and electrically controllable independently from each other. In this manner, considering for example two superimposed stacks, one stack is used to generate the acoustic waves (e.g., it is biased with the drive signal) and the other stack is used to create the additional stress in the membrane 20 which modifies the mechanical and therefore vibrational properties of the membrane 20 (e.g., it is biased with the modulation signal).

Another example is known from the prior art document US 2017/0095837 A1 that discloses a receiving element that is formed by a piezoelectric element that is configured to include a vibrating film, where a piezoelectric body is disposed on one surface side of the vibrating film, first and second electrodes that form a horizontal electrode structure disposed on the upper surface (surface not facing the vibrating film) of the piezoelectric body. The vibrating film is formed as a flexible film by laminating a silicon oxide (SiO2) layer and a zirconium oxide (ZrO2) layer. The first and second electrodes are formed of a conductive material and have a horizontal electrode structure in which the first and second electrodes are disposed on the upper surface of the piezoelectric body with a predetermined gap therebetween. Both of the vibrating film and the piezoelectric body have rectangular shapes in plan view, and are formed so that the respective sides are parallel and the centers match each other. In addition, the first and second electrodes are disposed so as to be line-symmetric with respect to the centerline parallel to one side of the piezoelectric body. On the other surface side (surface not facing the piezoelectric body) of the vibrating film, in order to support the piezoelectric element and form a cavity opening for receiving an ultrasonic wave, silicon side walls that are side wall portions are disposed so as to interpose a first recess portion of the vibrating film. The first recess portion of the piezoelectric element is formed on the other surface side (side opposite to the piezoelectric body side) of the vibrating film so as to overlap a gap portion between the first and second electrodes of the piezoelectric body in plan view, and a second recess portion is formed in a gap portion between the first and second electrodes of the piezoelectric body. The first and second recess portions are provided at corresponding positions on the front and back surfaces of the piezoelectric element. Both of the first and second recess portions are formed in a groove shape extending in a direction crossing the electrode arrangement direction of the horizontal electrode structure.

However, in known solutions the frequency of the acoustic waves, measured between the MUT device 1 (i.e. the ultrasonic transducer T) and the object O to be detected, does not depend on their emission direction and therefore on the relative angle between the MUT device 1 and the object O. In detail, the relative angle between the MUT device 1 and the object O is given by a tilting angle $\theta$ defined between the emission direction 24 and a reference direction 22 orthogonal to the first main face 3A of the semiconductor body 3. For example, the emission direction 24 joins the object O (exemplarily considered point-like) and the MUT device 1 (for example, a center of the membrane 20, taken in an XY plane defined by the X and Y axes and parallel to the first main face 3A of the semiconductor body 3). In known solutions, the frequency of the acoustic waves is invariant with respect to the tilting angle $\theta$.

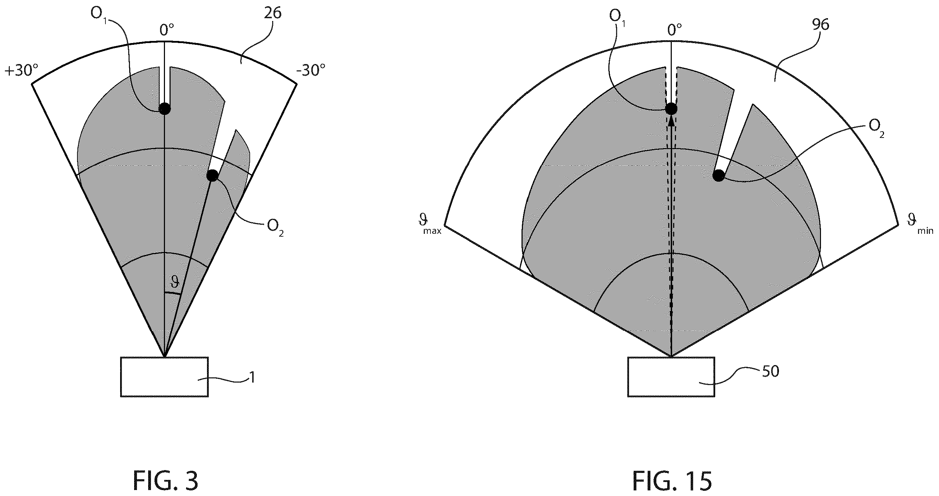

This is a relevant limit of the known solutions since it prevents the MUT device 1 from performing selective measurements on a desired object O; conversely, in the presence of multiple objects O present in the field-of-view (FOV) of the MUT device 1, the latter detects only the object O closest to the MUT device 1. In other words and as shown in Figure 3, when for example a first object $O_1$ and a second object $O_2$ are present in the FOV 26 of the MUT device 1 (the first object $O_1$ being at a null tilting angle $\theta$ and distant from the MUT device 1 by a first distance $D_1$ and the second object $O_2$ being at a non-null tilting angle $\theta$ and distant from the MUT device 1 by a second distance $D_2$ smaller than the first distance $D_1$), the MUT device 1 detects only the second distance $D_2$.

The aim of the present invention is to provide a MEMS ultrasonic transducer device, a manufacturing process and a control method of the MEMS ultrasonic transducer device, which overcome the drawbacks of the prior art.

According to the present invention, a MEMS ultrasonic transducer device, a manufacturing process and a control method of the MEMS ultrasonic transducer device are provided, as defined in the annexed claims.

For a better understanding of the present invention, a preferred embodiment is now described, purely by way of non-limiting example, with reference to the attached drawings, wherein:

- Figure 1 schematically shows the operation of an ultrasonic transducer of a known type;
- Figure 2 is a cross-sectional view of a MEMS ultrasonic transducer, MUT, of a known type;
- Figure 3 schematically shows the type of detection operated by a MUT of a known type;

- Figures 4-7 are cross-sectional views of respective embodiments of a MEMS ultrasonic transducer, MUT, device where Figures 4 and 5 are taken along a section line shown in Figure 9A and Figures 6 and 7 are taken along a section line shown in Figure 9B;
- Figure 8 is a cross-sectional view of a detail of the MUT device of Figures 4-7;
- Figures 9A-9F are top views of respective embodiments of the present MUT device;
- Figures 10A-10B are cross-sectional views of the MUT device of Figure 6 that illustrate the operation thereof in two different states;
- Figures 11A-11B are cross-sectional views of the MUT device of Figure 7 that illustrate the operation thereof in two different states;
- Figure 12 is a graph showing, as a function of time, the displacement of a modulation membrane of the present MUT device;
- Figures 13A-13D are cross-sectional views illustrating respective steps of a manufacturing process of the MUT device of Figure 4;
- Figures 14A-14D are cross-sectional views which illustrate respective steps of a manufacturing process of the MUT device of Figure 5; and
- Figure 15 schematically shows the type of detection operated by the present MUT device.

In particular, the Figures are shown with reference to a triaxial Cartesian system defined by an X axis, a Y axis and a Z axis (or first axis Z), orthogonal to each other.

In the following description, elements common to the different embodiments have been indicated with the same reference numbers.

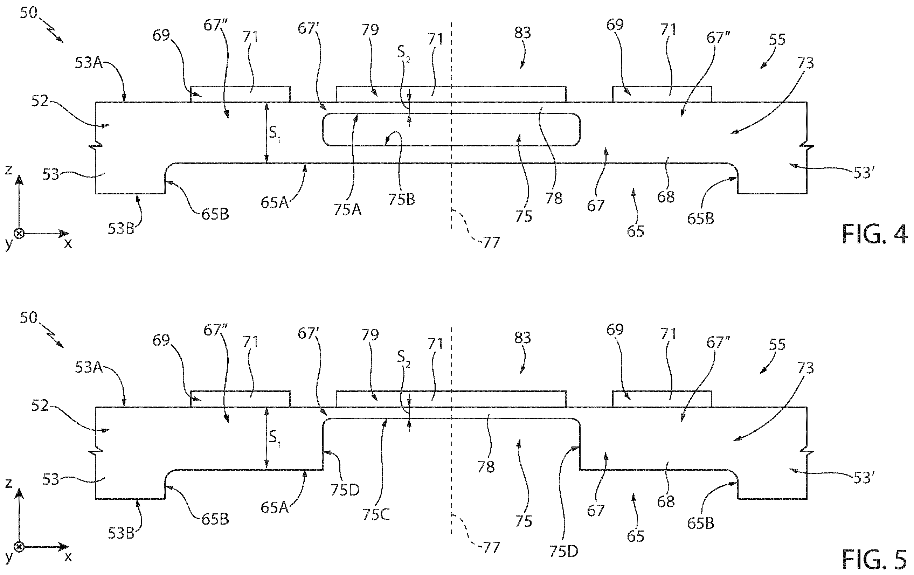

Figure 4 schematically shows an ultrasonic transducer device 50 made using MEMS technology, and therefore hereinafter also referred to as MUT ("Micromachined Ultrasonic Transducer") device.

For example, the MUT device 50 is integrated in a die 52. The die 52 comprises a semiconductor body 53 of semiconductor material, such as silicon, for example monolithic, having a first and a second main face (or surface) 53A, 53B opposite to each other along the Z axis.

The MUT device 50 integrates one or more MEMS ultrasonic transducer elements (or MUT elements) 55. In the embodiment exemplarily shown in Figure 4 and discussed hereinbelow, the MUT device 50 comprises a single MUT element 55; nevertheless the MUT device 50 may comprise a plurality of MUT elements 55.

The MUT element 55 is formed in the semiconductor body 53.

In particular, the MUT element 55 has a modulation cavity 65 which extends into the semiconductor body 53, from the second main face 53B of the semiconductor body 53 towards the first main face 53A of the semiconductor body 53, without reaching the latter. In detail, the modulation cavity 65 is upwardly delimited by a first bottom surface 65A of the semiconductor body 53 and is laterally delimited by first lateral surfaces 65B of the semiconductor body 53 which join the first bottom surface 65A of the semiconductor body 53 with the second main face 53B of the semiconductor body 53. In other words, the modulation cavity 65 has the first bottom surface 65A and, opposite thereto along the Z axis, an opening wherethrough the modulation cavity 65 communicates with the outside of the MUT device 50.

The portion of the semiconductor body 53 extending between the modulation cavity 65 and the first main face 53A of the semiconductor body 53 forms a membrane body 67 of the MUT element 55.

In particular, the semiconductor body 53 defines a support structure 53' which supports and anchors the membrane body 67 in such a way that the latter is suspended on the modulation cavity 65. In use, the membrane body 67 oscillates relatively to the support structure 53'.

In detail, the membrane body 67 comprises a central portion 67' defining a transduction membrane body 78, and one or more extremal portions 67" defining a modulation membrane body 68. The extremal portions 67" of the membrane body 67 are interposed between the central portion 67' of the membrane body 67 and the support structure 53', so as to couple the latter to each other. In greater detail, the central portion 67' of the membrane body 67 is interposed, orthogonally to the Z axis (e.g., along the X axis), between the extremal portions 67" of the membrane body 67; in other words, the transduction membrane body 78 is, orthogonally to the Z axis, internal and, in detail, central with respect to the modulation membrane body 68.

More in detail, the modulation membrane body 68 has a thickness, along the Z axis, equal to a first thickness $S_1$. In greater detail, the first thickness $S_1$ is measured along the Z axis between the first main face 53A of the semiconductor body 53 and the first bottom surface 65A. For example, the first thickness $S_1$ is comprised between about 5 $\mu$m and about 50 $\mu$m, in particular between about 10 $\mu$m and about 20 $\mu$m. In particular, the modulation membrane body 68 has a thickness, along the Z axis, that is substantially uniform; for example, the first thickness $S_1$ is the minimum thickness of the modulation membrane body 68 along the Z axis.

A piezoelectric modulation structure 69 of the MUT element 55 is present on the modulation membrane body 68, above the first main face 53A. The piezoelectric modulation structure 69 forms, together with the modulation membrane body 68, a modulation membrane 73 of the MUT element 55. In particular, the piezoelectric modulation structure 69 comprises one or more piezoelectric elements 71 configured to vibrate the modulation membrane 73, as better described hereinbelow.

The MUT element 55 also has a transduction cavity 75 that extends into the central portion 67' of the membrane body 67.

In the embodiment of Figure 4, the transduction cavity 75 is of the buried type and, for example, is arranged at the first main face 53A of the semiconductor body 53. In detail, the transduction cavity 75 extends into the semiconductor body 53 so as to be surrounded by the latter, and therefore to be buried therein and insulated (i.e. not communicating) with respect to an environment external to the MUT device 50. For example, the transduction cavity 75 is closer to the first main face 53A of the semiconductor body 53 than to the first bottom surface 65A. In detail, the transduction cavity 75 is upwardly delimited by a first cavity surface 75A of the semiconductor body 53 and is downwardly delimited by a second cavity surface 75B of the semiconductor body 53, opposite to each other along the Z axis with respect to the transduction cavity 75.

The portion of the semiconductor body 53 (in detail, of the central portion 67' of the membrane body 67) extending between the transduction cavity 75 and the first main face 53A of the semiconductor body 53 forms the transduction membrane body 78.

In detail, the transduction membrane body 78 has a thickness, along the Z axis, equal to a second thickness $S_2$ lower than the first thickness $S_1$. In greater detail, the second thickness $S_2$ is measured along the Z axis between the first main face 53A of the semiconductor body 53 and the first cavity surface 75A of the semiconductor body 53. For example, the second thickness $S_2$ is comprised between about 500 nm and about 8 $\mu$m, in particular between about 1 $\mu$m and about 2 $\mu$m. In particular, the transduction membrane body 78 has a thickness, along the Z axis, that is substantially uniform; for example, the second thickness $S_2$ is the maximum thickness of the transduction membrane body 78 along the Z axis.

A piezoelectric transduction structure 79 of the MUT element 55 is present on the transduction membrane body 78, above the first main face 53A. The piezoelectric transduction structure 79 forms, together with the transduction membrane body 78, a transduction membrane 83 of the MUT element 55. In particular, the piezoelectric transduction structure 79 comprises one or more piezoelectric elements 71 configured to generate and/or detect vibrations of the transduction membrane 83, as better described hereinbelow.

The piezoelectric transduction structure 79 is superimposed, along the Z axis, on the transduction cavity 75 and is arranged side by side, orthogonally to the Z axis (e.g., along the X axis), to the piezoelectric modulation structure 69 which is instead vertically staggered with respect to the transduction cavity 75 (i.e. it is not superimposed, along the Z axis, on the transduction cavity 75).

In detail, the MUT element 55 may have axial symmetry along a central axis 77 parallel to or coincident with the Z axis.

In greater detail, the transduction cavity 75 and the modulation cavity 65 are concentric and coaxial along the central axis 77. In other words, the transduction cavity 75 and the modulation cavity 65 (here exemplarily considered with a circular shape orthogonally to the Z axis) have, orthogonally to the Z axis, centers that are aligned with each other along the central axis 77. The transduction membrane body 78 and the modulation membrane body 68 are therefore also concentric and coaxial with each other and with respect to the transduction cavity 75 and the modulation cavity 65 and, in the example considered, they also have a circular shape. In detail, the modulation membrane body 68 is radially external to the transduction membrane body 78 with respect to the central axis 77.

For example, the transduction membrane body 78 has, parallel to the XY plane (therefore orthogonally to the Z axis), a smaller area than the modulation membrane body 68; similarly, the transduction cavity 75 has, parallel to the XY plane, a smaller area than the modulation cavity 65.

Furthermore, for example, the cavities 65, 75 and therefore the respective membrane bodies 68, 78 have an area (parallel to the XY plane) that is greater with respect to the area of the respective piezoelectric structures 69, 79, such that their peripheral zones, here exemplarily having the shape of a circular ring, protrude laterally with respect to the respective piezoelectric structures 69, 79.

Figure 5 shows a further embodiment of the MUT device 50.

The MUT device 50 of Figure 5 is similar to that of Figure 4, however the transduction cavity 75 is not of the buried type but of the exposed type and faces (i.e. communicates with) the modulation cavity 65.

In detail, the transduction cavity 75 extends into the membrane body 67, from the first bottom surface 65A towards the first main face 53A of the semiconductor body 53, without reaching the latter. In detail, the transduction cavity 75 is upwardly delimited by a second bottom surface 75C of the semiconductor body 53, whose distance along the Z axis from the first main face 53A of the semiconductor body 53 defines the second thickness $S_2$; furthermore, the transduction cavity 75 is laterally delimited by second lateral surfaces 75D of the semiconductor body 53 which join the third bottom surface 75C with the first bottom surface 65A. In other words, the transduction cavity 75 has the second bottom surface 75C and, opposite thereto along the Z axis, an opening which extends through the first bottom surface 65A and wherethrough the transduction cavity 75 communicates with the modulation cavity 65. The cavities 65 and 75 are therefore axially adjacent along the central axis 77.

In detail, the first bottom surface 65A and the second bottom surface 75C are part of a rear surface of the membrane body 67, having variable height along the Z axis and in particular having two levels (an internal level and an external level which is radially external to the internal level and is axially more distant from the first main face 53A than the internal level).

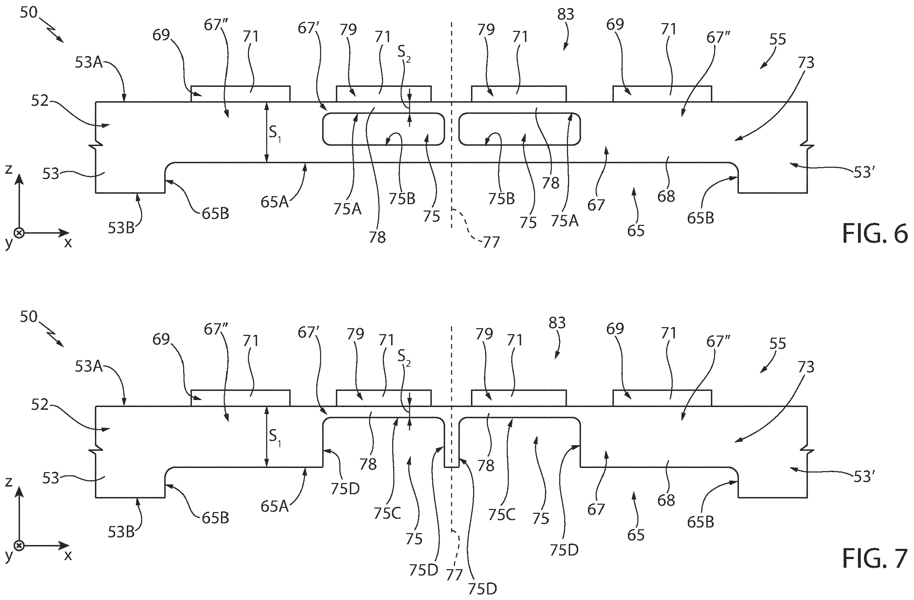

Figure 6 shows a further embodiment of the MUT device 50.

The MUT device 50 of Figure 6 is similar to that of Figure 4, however a plurality of transduction cavities 75 of the buried type are present in the central portion 67' of the membrane body 67, instead of just one. By way of example, Figure 6 shows two transduction cavities 75; nevertheless, the number of transduction cavities 75 may similarly be greater.

In detail, the transduction cavities 75 are arranged side by side to each other orthogonally to the Z axis (e.g., along the X axis) and are spaced from each other so as to be insulated from each other.

The portions of the semiconductor body 53 extending between each transduction cavity 75 and the first main face 53A of the semiconductor body 53 form respective transduction membrane bodies 78 with a thickness, along the Z axis, equal to the second thickness $S_2$.

A respective piezoelectric transduction structure 79 of the MUT element 55 is present on each transduction membrane body 78, above the first main face 53A. The piezoelectric transduction structures 79 are arranged side by side to each other orthogonally to the Z axis (e.g., along the X axis), in particular at a distance from each other, and form, together with the respective transduction membrane bodies 78, respective transduction membranes 83 of the MUT element 55. In particular, each piezoelectric transduction structure 79 comprises one or more of said piezoelectric elements 71 configured to generate and/or detect vibrations of the respective transduction membrane 83.

The piezoelectric transduction structures 79 are therefore superimposed, along the Z axis, on the respective transduction cavities 75 and are arranged side by side, orthogonally to the Z axis (e.g., along the X axis), to the piezoelectric modulation structure 69 which is instead vertically staggered with respect to the transduction cavities 75.

Figure 7 shows a further embodiment of the MUT device 50.

The MUT device 50 of Figure 7 is similar to that of Figure 5, however a plurality of transduction cavities 75 of the exposed type are present in the central portion 67' of the membrane body 67, instead of just one. By way of example, Figure 7 shows two transduction cavities 75; nevertheless, the number of transduction cavities 75 may similarly be greater.

In detail, the transduction cavities 75 are arranged side by side to each other orthogonally to the Z axis (e.g., along the X axis) and are spaced from each other so as to be insulated from each other.

The portions of the semiconductor body 53 extending between each transduction cavity 75 and the first main face 53A of the semiconductor body 53 form respective transduction membrane bodies 78 with a thickness, along the Z axis, equal to the second thickness $S_2$.

A respective piezoelectric transduction structure 79 of the MUT element 55 is present on each transduction membrane body 78, above the first main face 53A. The piezoelectric transduction structures 79 are arranged side by side to each other orthogonally to the Z axis (e.g., along the X axis), in particular at a distance from each other, and form, together with the respective transduction membrane bodies 78, respective transduction membranes 83 of the MUT element 55. In particular, each piezoelectric transduction structure 79 comprises one or more of said piezoelectric elements 71 configured to generate and/or detect vibrations of the respective transduction membrane 83.

The piezoelectric transduction structures 79 are therefore superimposed, along the Z axis, on the respective transduction cavities 75 and face, orthogonally to the Z axis (e.g., along the X axis), the piezoelectric modulation structure 69 which is instead vertically staggered with respect to the transduction cavities 75.

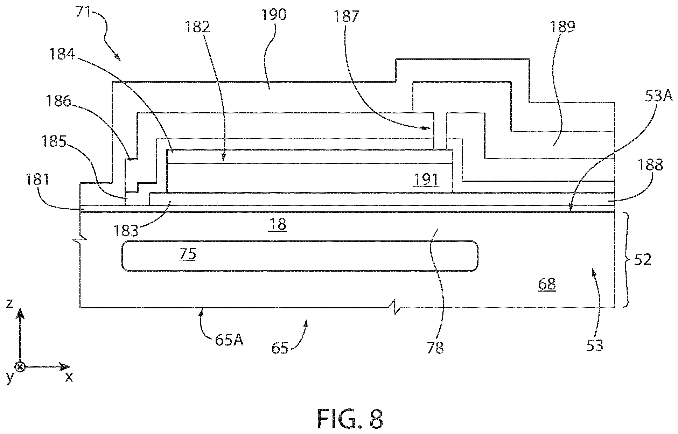

Figure 8 shows, by way of non-limiting example, an example of structure of the piezoelectric element 71 of the piezoelectric modulation structure 69 and of the piezoelectric transduction structure 79. For example, Figure 8 exemplarily shows the piezoelectric element 71 of the piezoelectric transduction structure 79.

In detail, the piezoelectric element 71 is formed above an insulating layer 181, for example formed by the superimposition of a thermally grown silicon oxide layer and a dielectric layer, and covers the entire first main face 53A of the semiconductor body 53. Above the insulating layer 181, there extends a stack 182 comprising: a bottom electrode 183, of electrically conductive material, for example of titanium (Ti) or platinum (Pt); a thin-film piezoelectric region 191; and a top electrode 184, for example of TiW. The bottom electrode 183 is in electrical contact with a first contact line 188 (for example, it is formed in the same layer and patterned through known photolithographic steps). A first and a second dielectric layer 185, 186, for example of silicon oxide and silicon nitride deposited by CVD (Chemical Vapor Deposition) extend on the stack 182. A second contact line 189 of conductive material, for example of aluminum and/or copper, extends above the dielectric layers 185, 186 and into an opening 187 thereof, to electrically contact the top electrode 184. Optionally, a passivation layer 190, for example of silicon oxide and/or nitride deposited by CVD, covers all the top surface of the die 52, except for the electrical connection openings (above contact pads of the MUT element 55). In practice, the contact lines 188, 189 form electrical connections and allow: in order to generate the emitted wave $W_e$ by the MUT element 55, the electrical connection of one of the electrodes 183, 184 (for example the bottom electrode 183) to a reference potential, typically to ground, and the biasing of the other of the electrodes 183, 184 (for example of the top electrode 184) to an AC actuation voltage; or, in order to detect the reflected wave $W_r$, the acquisition of a detection potential difference between the electrodes 183 and 184 induced by the impingement of the reflected wave W$_r$ on the transduction membrane 83.

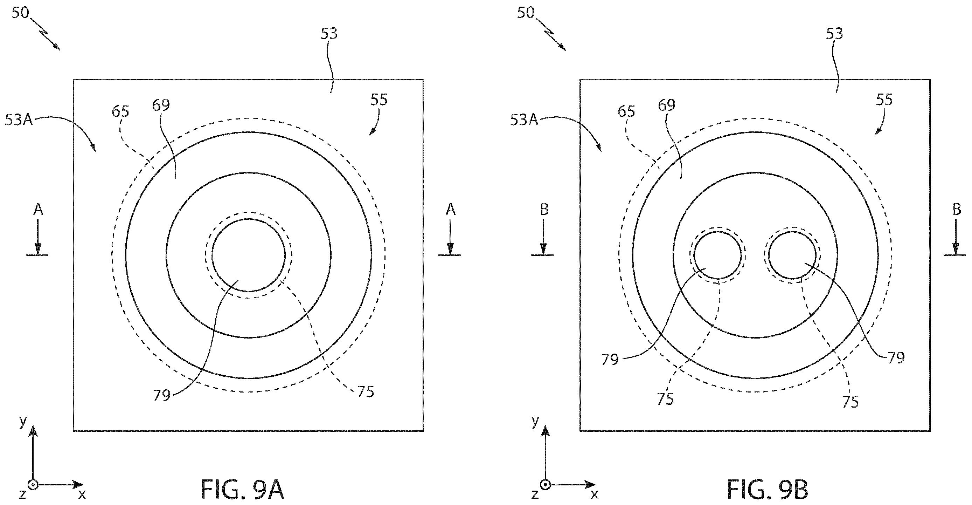

Figures 9A-9F schematically show top views of the MUT device 50. In other words, these views are taken orthogonally to the Z axis, i.e. parallel to the XY plane.

In particular, Figure 9A shows a top view of the MUT device 50 of Figure 4 or 5. As exemplarily shown in Figure 9A, the transduction membrane body 78, the piezoelectric transduction structure 79, the transduction cavity 75, the modulation membrane body 68, the piezoelectric modulation structure 69 and the modulation cavity 65 have, parallel to the XY plane, a substantially circular shape and are concentric with each other.

Figure 9B shows a top view of the MUT device 50 of Figure 6 or 7. As exemplarily shown in Figure 9B, the transduction membrane body 78, the piezoelectric transduction structures 79, the transduction cavities 75, the modulation membrane body 68, the piezoelectric modulation structure 69 and the modulation cavity 65 have, parallel to the XY plane, a substantially circular shape. The piezoelectric modulation structure 69, the modulation membrane body 68 and the modulation cavity 65 are concentric with each other, as well as each piezoelectric transduction structure 79 with the respective transduction membrane body 78 and the respective transduction cavity 75. In particular, the transduction membrane bodies 78 are surrounded by the modulation membrane body 68 which joins them to the support structure 53'.

Although Figures 9A and 9B show circular shapes of the illustrated elements, other closed polygonal shapes may be similarly used (e.g., triangular, square, hexagonal shape, etc.). Furthermore, other shapes and arrangements of the piezoelectric modulation structure 69 and the modulation cavity 65 relative to the piezoelectric transduction structures 79 and the transduction cavities 75 are possible.

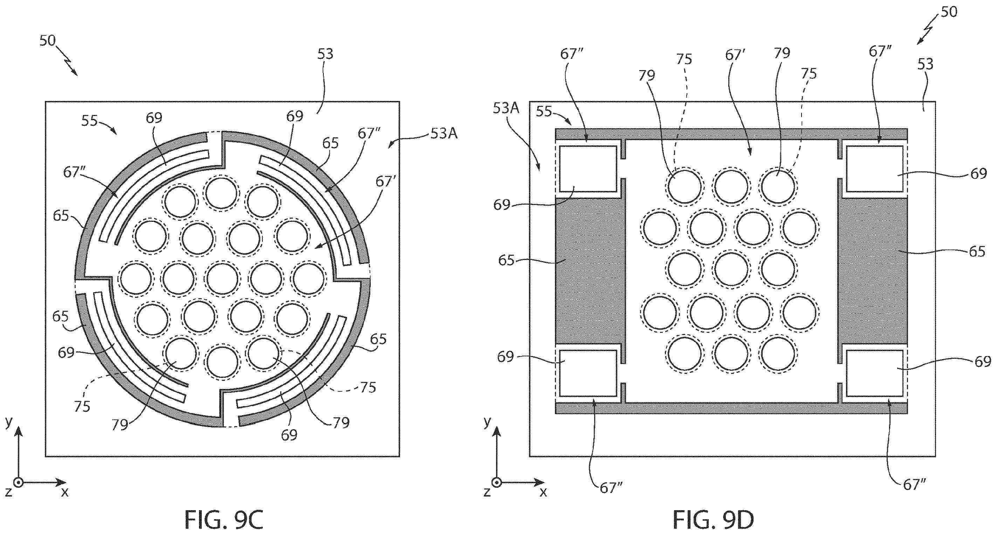

For example, in the embodiment of Figure 9C the modulation membrane body 68 is formed by a plurality of said extremal portions 67" of the membrane body 67. In top view, the central portion 67' of the membrane body 67 has a circular shape and the extremal portions 67" have an annular sector shape and are arranged circumferentially one adjacent to the other. In particular, each extremal portion 67" has a first end and a second end that are opposite to each other along the main extension of the extremal portion 67" (i.e. circumferentially to the central portion 67'); the extremal portions 67" are fixed to the support structure 53' through the respective first ends and are fixed to the central portion 67' of the membrane body 67 through the respective second ends. Furthermore, the central portion 67' of the membrane body 67 comprises a plurality of transduction cavities 75, for example arranged substantially homogeneously in the central portion 67', and therefore comprises a respective plurality of transduction membrane bodies 78, each vertically overlaid by the respective piezoelectric transduction structure 79.

In the embodiment of Figure 9D, the central portion 67' has a quadrangular, in particular square, shape. The modulation membrane body 68 is formed by a plurality of said extremal portions 67" of the membrane body 67, connected to the vertices of the central portion 67'. For example, the extremal portions 67" also have a quadrangular, in particular square or rectangular, shape, and have the respective first ends fixed to the support structure 53' and the respective second ends fixed to the vertices of the central portion 67'. Similarly to Figure 9C, the central portion 67' of the membrane body 67 comprises a plurality of transduction cavities 75 (and therefore of transduction membrane bodies 78), for example arranged substantially homogeneously in the central portion 67'.

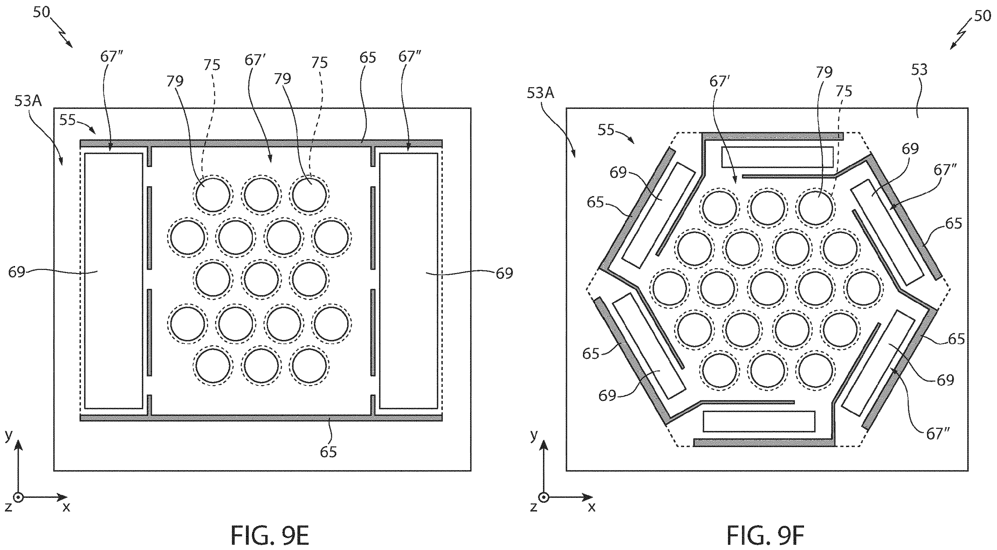

In the embodiment of Figure 9E, the central portion 67' has a quadrangular, in particular square, shape. The modulation membrane body 68 is formed by two extremal portions 67" of the membrane body 67, for example of quadrangular (in particular, rectangular) shape, which have a longitudinal extension substantially equal to the length of the sides of the central portion 67' and which are respectively connected to sides, opposite to each other, of the central portion 67'. Similarly to Figure 9C, the central portion 67' of the membrane body 67 comprises a plurality of transduction cavities 75 (and therefore of transduction membrane bodies 78), for example arranged substantially homogeneously in the central portion 67'.

In the embodiment of Figure 9F, the modulation membrane body 68 is formed by a plurality of said extremal portions 67" of the membrane body 67. In top view, the central portion 67' of the membrane body 67 has a hexagonal shape and the extremal portions 67" have a substantially rectangular shape and are each arranged side by side to a respective side of the central portion 67', so as to be arranged circumferentially one adjacent to the other. In particular, the extremal portions 67" are fixed to the support structure 53' through the respective first ends and are fixed to the vertices of the central portion 67' of the membrane body 67 through the respective second ends. Similarly to Figure 9C, the central portion 67' of the membrane body 67 comprises a plurality of transduction cavities 75 (and therefore of transduction membrane bodies 78), for example arranged substantially homogeneously in the central portion 67'.

In use, the MUT device 50 operates in a similar manner to the known devices (e.g., the ultrasonic transducer T of Figure 1). In particular, in use the MUT device 50 is surrounded by a propagation means (a fluid such as liquid or gas, in particular air) wherein acoustic waves (in detail, ultrasonic waves), generated or detected by the MUT device 50, propagate.

When the MUT element 55 is operated in an own emission mode (i.e. it works as an actuator), the membranes 73 and 83 are vibrated by the respective piezoelectric structures 69 and 79 and, as better described hereinbelow, the vibrations of the one or more transduction membranes 83 (relative to rest positions thereof) cause the generation and propagation in the propagation means of the acoustic waves.

In particular, a first actuation voltage, of the AC-type (e.g., at a first actuation frequency comprised between about 1 kHz and about 100 kHz, for example equal to about 10 kHz, and with a voltage equal to about 40 V), is applied between the electrodes 183 and 184 of the one or more piezoelectric elements 71 of the piezoelectric modulation structure 69 while a second actuation voltage, of the AC-type (e.g., at a second actuation frequency higher than the first actuation frequency and comprised between about 500 kHz and about 50 MHz, for example equal to about 5 MHz, and with a voltage equal to about 40 V), is applied between the electrodes 183 and 184 of the one or more piezoelectric elements 71 of the piezoelectric transduction structure 79. The application of the first actuation voltage causes, alternately, the contraction and expansion of the thin-film piezoelectric region 191 of the piezoelectric modulation structure 69 and therefore the resulting deflection of the modulation membrane 73 in the vertical direction, alternately moving away from and towards the modulation cavity 65. The application of the second actuation voltage causes, alternately, the contraction and expansion of the thin-film piezoelectric region 191 of the piezoelectric transduction structure 79 and therefore the resulting deflection of the transduction membrane 83 in the vertical direction, alternately moving away from and towards the transduction cavity 75. Since the first actuation frequency is much lower than the second actuation frequency (e.g., by about two orders of magnitude), the vibration of the modulation membrane 73 occurs in a much slower manner than the vibration of the transduction membrane 83 (i.e. the first vibration frequency of the modulation membrane 73 is lower, e.g. by about two orders of magnitude, with respect to the second vibration frequency of the transduction membrane 83). In particular, the first vibration frequency is equal to the first actuation frequency and the second vibration frequency is equal to the second actuation frequency. The simultaneous vibration of the membranes 73 and 83 causes the generation of acoustic waves which propagate in the propagation means from the MUT device 50 and which simultaneously depend on the movement of both membranes 73 and 83.

In particular, the vibrational movement of the modulation membrane 73 adds to the vibrational movement of the transduction membrane 83, thus generating a modulation of the frequency of the acoustic waves emitted with respect to the known case wherein the sole vibrational movement of the transduction membrane 83 (hereinafter referred to as acoustic wave reference frequency) is present.

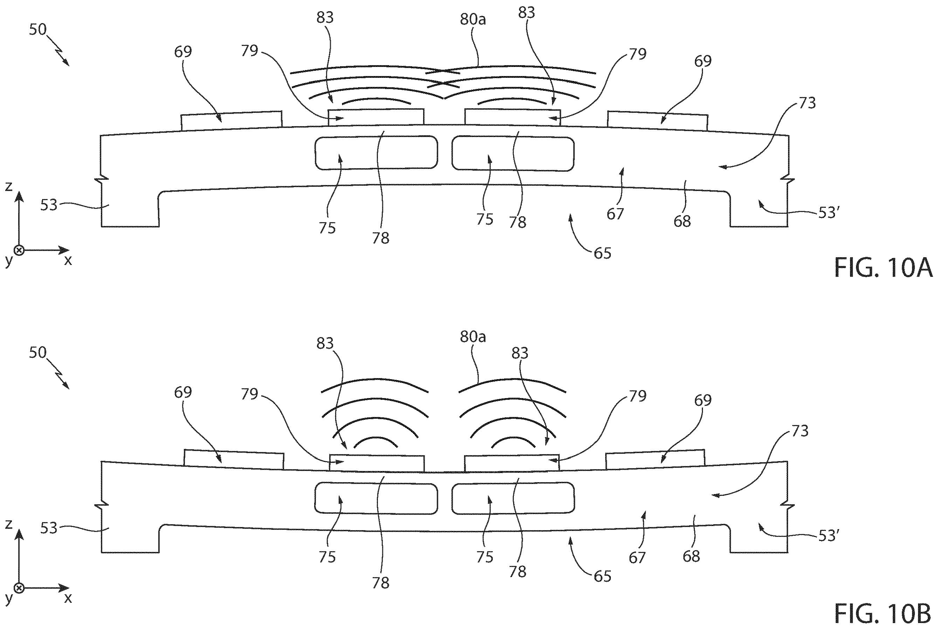

In fact, as exemplarily shown in Figures 10A and 10B exemplarily referring to the embodiment of the MUT device 50 of Figure 6, when the modulation membrane 73 deforms in the opposite direction with respect to the modulation cavity 65 (Figure 10A), the wavefronts propagating in the opposite direction with respect to the modulation cavity 65 (hereinafter also referred to as first wavefronts of the first acoustic waves 80a) are closer to each other since the movement of the modulation membrane 73 is concordant with the propagation direction of the first acoustic waves 80a; consequently, the frequency of the first acoustic waves 80a is higher than the reference frequency. On the other hand, when the modulation membrane 73 deforms towards the modulation cavity 65 (Figure 10B), the first wavefronts are more spaced from each other since the movement of the modulation membrane 73 is discordant with the propagation direction of the first acoustic waves 80a; consequently, the frequency of the first acoustic waves 80a is lower than the reference frequency.

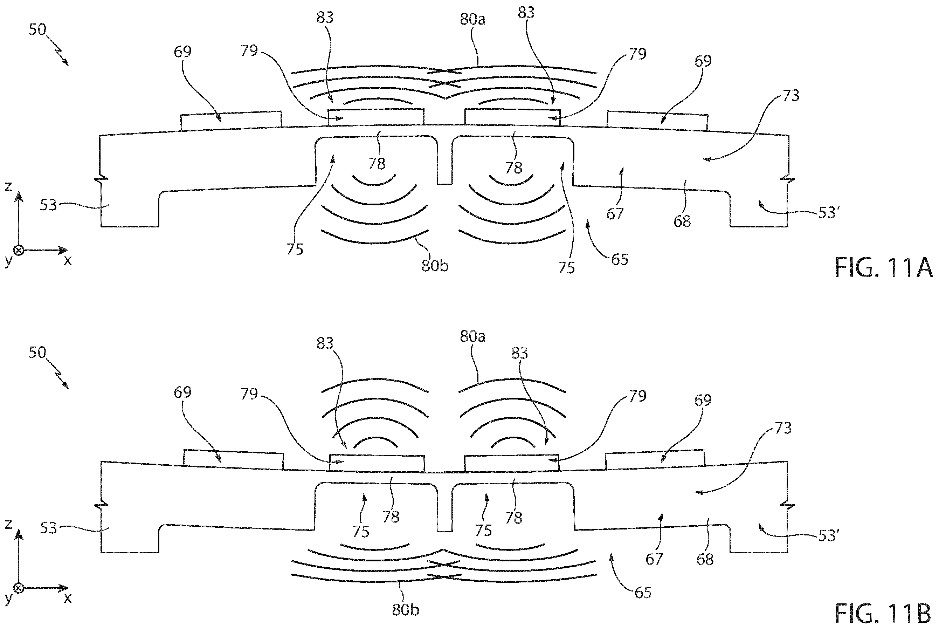

On the other hand, Figures 11A and 11B show the operation of the MUT device 50 of Figure 7. In this case, the behavior of the acoustic waves 80a (emitted from the front of the MUT device 50) is similar to that described with reference to Figures 10A and 10B. Furthermore, since the transduction cavities 75 are exposed towards the back of the MUT device 50 and face the modulation cavity 65, the vibrations of the transduction membranes 83 also generate second acoustic waves 80b which propagate through the modulation cavity 65. In particular, when the modulation membrane 73 deforms in the opposite direction with respect to the modulation cavity 65 (Figure 11A), the second wavefronts of the second acoustic waves 80b are more spaced from each other since the movement of the modulation membrane 73 is discordant with the propagation direction of the second acoustic waves 80b; consequently, the frequency of the second acoustic waves 80b is lower than the reference frequency. On the other hand, when the modulation membrane 73 moves towards the modulation cavity 65 (Figure 11B), the second wavefronts are closer to each other since the movement of the modulation membrane 73 is concordant with the propagation direction of the second acoustic waves 80b; consequently, the frequency of the second acoustic waves 80b is higher than the reference frequency.

In other words, the vibrational movement of the modulation membrane 73 modulates the frequency of the acoustic waves 80a, 80b through Doppler effect. The Doppler effect is the change in the frequency of a wave in relation to an observer moving with respect to the wave source (or vice versa). In this case, it is the wave source (i.e. the modulation membrane 73) that moves with respect to the observer (e.g., the object to be detected), thus generating the Doppler effect. This means that the frequency of the acoustic waves depends on the emission direction, as better described hereinbelow.

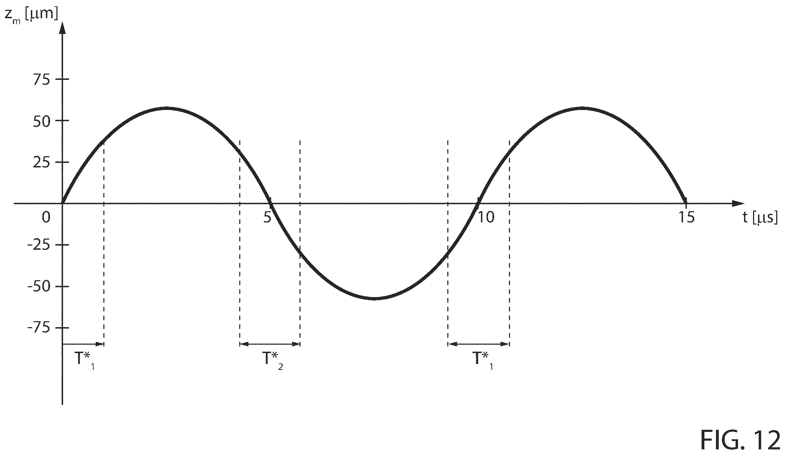

In detail, Figure 12 shows the vibrational movement of the modulation membrane 73, in particular shows, as a function of time, the displacement $Z_m$ of the modulation membrane 73 along the Z axis with respect to its rest position (defined when the first actuation voltage is not applied). The vibrational movement of the modulation membrane 73 is of substantially sinusoidal type around its rest position (considered null in Figure 12). Consequently, the MUT device 50 may be used in emission mode in predefined and periodic time intervals T*, wherein the modulation membrane 73 moves along the Z axis in an approximately linear manner; in particular, the time intervals T* are the time intervals wherein the displacement $Z_m$ of the modulation membrane 73 is comprised between about 60% of its maximum value and about 60% of its minimum value, or vice versa, and wherein, at a central instant of each time interval T*, the modulation membrane 73 is in its rest position. In other words, in the time intervals T* the displacement $Z_m$ is substantially linear in time. Therefore, in first time intervals $T*_1$ wherein the modulation membrane 73 moves in the opposite direction with respect to the modulation cavity 65, the MUT device 50 operates in linearity as previously described with reference to Figures 10A and 11A (therefore the frequency of the first acoustic waves 80a is higher and, possibly, the frequency of the second acoustic waves 80b is lower), while in second time intervals $T*_2$ wherein the modulation membrane 73 moves towards the modulation cavity 65, the MUT device 50 operates in linearity as previously described with reference to Figures 10B and 11B (therefore the frequency of the first acoustic waves 80a is lower and, possibly, the frequency of the second acoustic waves 80b is higher).

On the other hand, when the MUT element 55 is operated in an own reception mode (i.e. it works as a sensor), the acoustic waves coming from the propagation means (i.e. the reflected waves $W_r$) impinge on the one or more transduction membranes 83 and induce the vibration thereof. This vibration causes a stress in the piezoelectric element 71 of one or more piezoelectric transduction structures 79 which in turn generate electrical potential differences between the electrodes 183 and 184, indicative of the vibration of the transduction membrane 83 induced by the impinging acoustic waves. In particular, the frequency of the induced vibration of each transduction membrane 83 may be modulated by vibrating the modulation membrane 73 as previously described, i.e. by biasing each piezoelectric modulation structure 69 through the first actuation voltage and measuring the electric potential differences induced in the piezoelectric transduction structures 79 during the time intervals T*. Therefore, considerations on the Doppler effect, which are similar to those previously discussed with reference to the emission mode, also apply to the reception mode.

The reception mode and the emission mode are alternative to each other: the MUT device 50 may therefore operate only in reception, only in emission, or both in reception and in emission but in time periods alternating to each other.

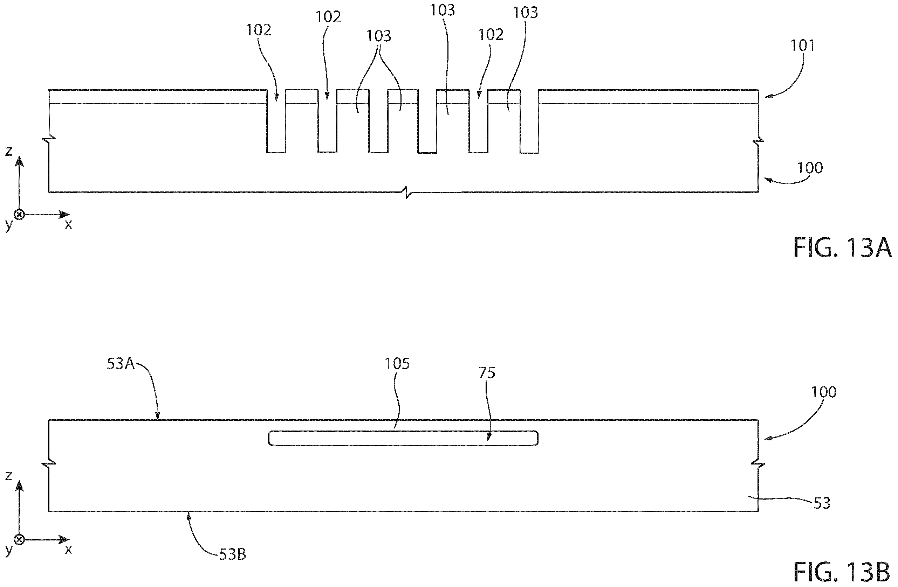

Figures 13A-13D show steps of a manufacturing process of the MUT device 50 of Figure 4.

Initially, Figure 13A, the transduction cavity 75 is formed in a wafer 100 of semiconductor material, for example monocrystalline silicon. For example, the manufacturing process described in the European patent EP1577656 and briefly summarized below may be used for this purpose.

In detail, a first mask 101 of resist having, at a region of the wafer 100 intended to accommodate the transduction cavity 75, openings arranged for example in a honeycomb lattice, is formed above the wafer 100 (i.e. on one top surface thereof). An anisotropic chemical etch of the wafer 100 is performed, by using the first mask 101, so as to form a plurality of trenches 102, having a depth of for example 10 $\mu$m, communicating with each other and delimiting a plurality of pillars (also called pillar structures) 103 of silicon.

Subsequently, Figure 13B, the first mask 101 is removed and an epitaxial growth is performed in a reducing environment. Consequently, an epitaxial layer, for example of the N-type and of a thickness of about 10 $\mu$m, grows above the pillars 103, closing the trenches 102 upwardly.

An annealing step is then performed, for example for 30 minutes at 1190°C, preferably in a hydrogen, or, alternatively, nitrogen atmosphere.

As discussed in the abovementioned document, the annealing step causes a migration of the silicon atoms which tend to move to a lower energy position. Consequently, also owing to the close distance between the pillars 103, the silicon atoms thereof migrate completely and the transduction cavity 75 is formed. A silicon layer with the second thickness $S_2$ along the Z axis, formed in part by epitaxially grown silicon atoms and in part by migrated silicon atoms and forming a closing layer 105 of monocrystalline silicon (which will become the transduction membrane body 78), remains above the transduction cavity 75. The wafer 100 thus processed forms the semiconductor body 53.

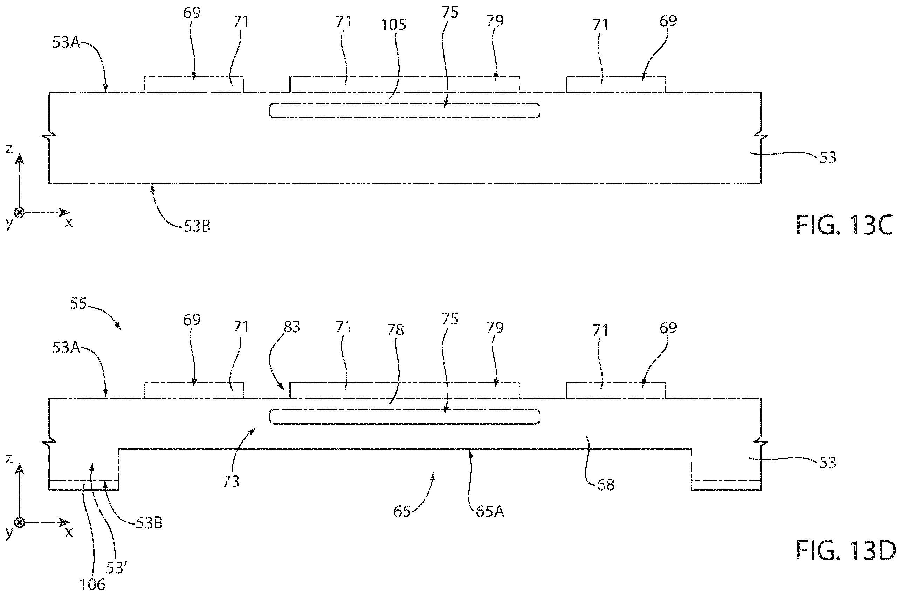

Then, Figure 13C, the piezoelectric elements 71 of the piezoelectric structures 69 and 79 are formed on the first main face 53A of the semiconductor body 53, in a per se known manner. In particular, the piezoelectric elements 71 are arranged side by side to each other along the X axis in such a way that the piezoelectric element 71 of the piezoelectric transduction structure 79 is vertically superimposed (along the Z axis) on the transduction cavity 75 while the one or more piezoelectric elements 71 of the piezoelectric modulation structure 69 are vertically staggered with respect to the transduction cavity 75.

For example and in a manner not shown in detail in Figure 13C, a first dielectric layer is deposited, on the first main face 53A of the semiconductor body 53, which forms the insulating layer 181, for example comprising insulating material such as $SiO_2$ and for example with a thickness of about 1 $\mu$m; in particular, this occurs by performing a thermal oxidation process of the wafer 100 which leads to the formation of the first dielectric layer on the first main face 53A of the semiconductor body 53 and of a second dielectric layer (similar to the first dielectric layer) on the second main face 53B of the semiconductor body 53. The piezoelectric elements 19 are formed on the insulating layer 181. For example, firstly the electrodes 183 and the first contact lines 188 are formed, by using known deposition and masking techniques. Then, a thin-film piezoelectric layer (for example of PZT - Pb, Zr, TiO3) and an electrode layer are deposited in succession, which are defined by known masking and definition techniques so as to form the thin-film piezoelectric regions 191 and the top electrodes 184. Then, the first and the second dielectric layers 185, 186 are deposited and defined, forming the openings 187; the second contact lines 189 are formed and the passivation layer 190 is deposited and defined, thus being opened on the contact pads (not shown),.

Then, Figure 13D, the modulation cavity 65 is formed by performing a first deep etch of the silicon from the back, at the second main face 53B of the semiconductor body 53.

In particular, the second dielectric layer is processed, through known oxide patterning techniques, to provide a second mask 106 of oxide having an opening that exposes the region of the semiconductor body 53 to be removed to form the modulation cavity 65. In detail, this region is aligned along the Z axis with the piezoelectric structures 69 and 79 and therefore with the transduction cavity 75. The first deep etch (e.g., anisotropic chemical etch) of the semiconductor body 53 is performed, by using the second mask 106, so as to form the modulation cavity 65 having a depth along the Z axis such as to define the modulation membrane body 68 having the first thickness $S_1$.

After carrying out the final manufacturing steps, including opening the contacts and dicing the wafer 100, the MUT device 50 of Figure 4 is obtained.

Similarly, the MUT device 50 of Figure 6 may also be obtained, in particular by forming multiple transduction cavities 75 arranged side by side to each other along the X axis and forming respective piezoelectric transduction structures 79 on the transduction cavities 75.

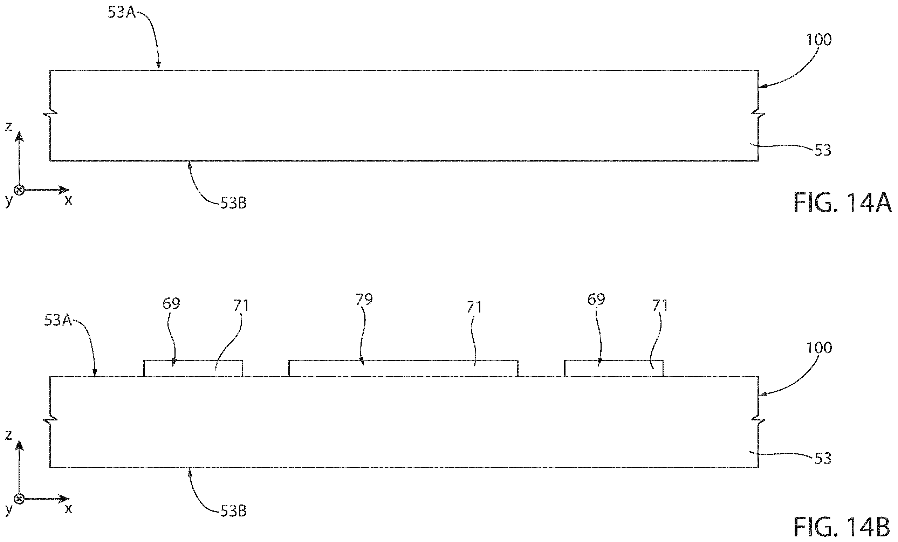

Figures 14A-14D show steps of the manufacturing process of the MUT device 50 of Figure 5.

Initially, Figure 14A, a wafer 100 of semiconductor material, for example monocrystalline silicon, is arranged which forms the semiconductor body 53.

The piezoelectric elements 71 of the piezoelectric structures 69 and 79 are formed, on the first main face 53A of the semiconductor body 53, Figure 14B, in a per se known manner. In particular, the piezoelectric elements 71 are arranged side by side to each other along the X axis. For example, and in a manner not shown in detail in Figure 14B, the formation of the piezoelectric elements 71 occurs similarly to what has been previously described with reference to Figure 13C.

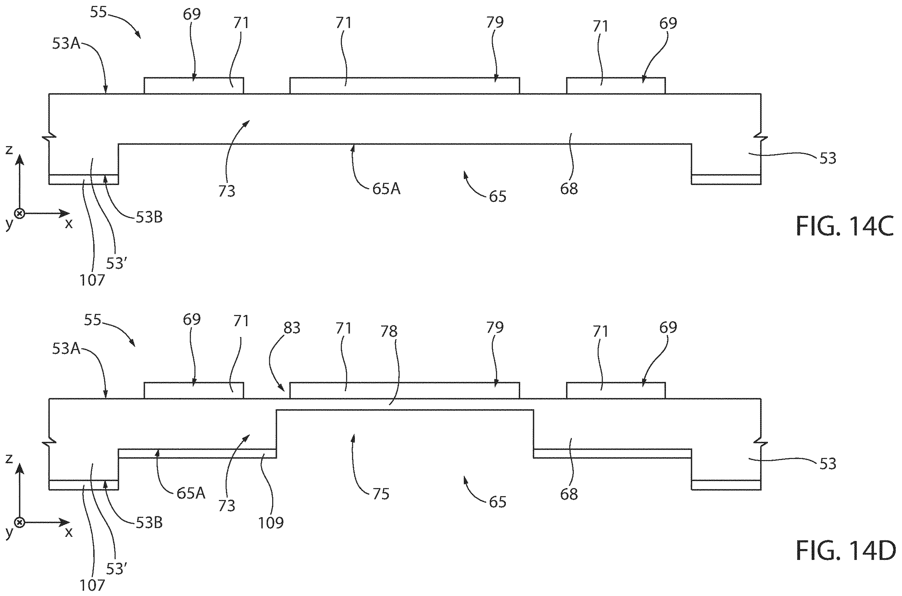

Then, Figure 14C, the modulation cavity 65 is formed performing a first deep etch of the silicon from the back, at the second main face 53B of the semiconductor body 53.

In particular, the second dielectric layer previously formed is processed, through known oxide patterning techniques, to provide a first mask 107 of oxide having an opening that exposes the region of the semiconductor body 53 to be removed to form the modulation cavity 65. In detail, this region is aligned along the Z axis with the piezoelectric structures 69 and 79. The first deep etch (e.g., anisotropic chemical etch) of the semiconductor body 53 is performed, by using the first mask 107, so as to form the modulation cavity 65 having a depth along the Z axis such as to define the modulation membrane body 68 having the first thickness $S_1$.

Then, Figure 14D, the transduction cavity 75 is formed by performing a second deep etch of the silicon from the back, at the first bottom surface 65A.

In particular, a third dielectric layer is formed on the first bottom surface 65A of the semiconductor body 53, similarly to what has been described for the second dielectric layer. The third dielectric layer provides a second mask 109 of oxide having an opening that exposes the region of the semiconductor body 53 to be removed to form the transduction cavity 75. In detail, this region is aligned along the Z axis with the piezoelectric transduction structure 79. The second deep etch (e.g., anisotropic chemical etch) of the semiconductor body 53 is performed, by using the second mask 109, so as to form the transduction cavity 75 in depth along the Z axis such as to define the transduction membrane body 78 having the second thickness $S_2$.

After carrying out the final manufacturing steps, including opening the contacts and dicing the wafer 100, the MUT device 50 of Figure 5 is obtained.

Similarly, the MUT device 50 of Figure 7 may also be obtained, in particular by forming multiple piezoelectric transduction structures 79 arranged side by side to each other along the X axis and forming respective transduction cavities 75 aligned along the Z axis with the piezoelectric transduction structures 79.

From an examination of the characteristics of the invention made according to the present invention, the advantages that it affords are evident.

In particular, the MUT device 50 generates acoustic waves whose frequency is modulable, allowing a better correspondence of the generated acoustic waves with the properties of the propagation means and of the object to be detected and thus ensuring better performances of the MUT device 50 in a greater range of applications.

Furthermore, it has been verified that the MUT device 50 allows generating wavefronts (e.g., of the first or the second acoustic waves 80a and 80b) with a frequency $f_o$ which depends on the emission direction of the acoustic waves. In other words, the frequency $f_o$ is a function of the tilting angle $\theta$ considered between the emission direction of the acoustic waves and the reference direction orthogonal to the first main face 53A of the semiconductor body 53 (e.g., the central axis 77). In particular, the tilting angle $\theta$ is defined between the reference direction and an emission direction which is indicative of the position of the object O to be detected relative to the MUT device 50 and which, for example, joins the object O to be detected (exemplarily considered point-like) and the MUT device 50 (in detail, a reference point of the MUT device 50, such as a center of the central portion 67' of the membrane body 67 in top view).

In particular, by applying the first actuation voltage with a sinusoidal profile to the first actuation frequency, the modulation membrane 73 oscillates at the first vibration frequency (here indicated with the reference $f_{r1}$ and equal to the first actuation frequency) and the displacement $Z_m$ of the modulation membrane 73 along the Z axis is of the sinusoidal type.

In this case, the oscillation speed $V_m$ of the modulation membrane 73 is equal to $V_m(t) = 2\pi f_{r1} Z_1 sin(2\pi f_{r1}t)$, where $Z_1$ is the oscillation amplitude of the modulation membrane 73 (i.e. double the maximum value of the displacement of the modulation membrane 73 along the Z axis with respect to its rest position). Furthermore, $V_s(t,\theta) = V_m(t) \cdot cos(\theta)$ is the relative speed between the MUT device 50 and the object O to be detected (i.e. between the acoustic source and the observer) and is a function of the tilting angle $\theta$.

Furthermore, the emitted or detected acoustic waves have a frequency (here indicated with the reference $f_o$ and also hereinafter referred to as acoustic wave frequency) which is equal to:

$$f_o(t, \theta) = \frac{f_{r2}}{1 - V_s(t, \theta)/c}$$

where c is the speed of sound in the fluid wherein the MUT device 50 is immersed (for example in the case of applications in air the speed of sound is about 340 m/s) and $f_{r2}$ is the second vibration frequency of the transduction membrane 83 (equal to the second actuation frequency).

In greater detail, the emitted or detected acoustic waves have a frequency difference $D_f$, relative to the second actuation frequency $f_{r2}$, which is equal to:

$$D_f(t, \theta) = f_o(t, \theta) - f_{r2} = f_{r2} \cdot \left( \frac{1}{1 - \frac{V_s(t,\theta)}{c}} - 1 \right) = \frac{f_{r2}}{\frac{c}{V_s(t,\theta)} - 1}$$

Furthermore, $V_{m,max} = 2\pi f_{r1} Z_1$ is the maximum value of the oscillation speed $V_m$ of the modulation membrane 73.

Purely for illustrative and non-limiting purposes, the following example embodiment of the MUT device 50 are reported. In addition to what has been indicated above, $D_{f,max}$ indicates the maximum value of the frequency difference $D_f$ and $D_{f,min}$ indicates the minimum value of the frequency difference $D_f$, where $D_{f,max}$ and $D_{f,min}$ may be different from each other in absolute value and are defined by the following expressions:

$$D_{f,max} = \frac{f_{r2}}{\frac{c}{2\pi f_{r1} Z_1} - 1}$$

$$D_{f,min} = -\frac{f_{r2}}{\frac{c}{2\pi f_{r1} Z_1} + 1}$$

According to a first example, $f_{r1}$=10kHz, $Z_1$=50$\mu$m, $f_{r2}$=5MHz, $D_{f,max}$=46.6kHz, $D_{f,min}$=-45.7kHz. According to a second example, $f_{r1}$=10kHz, $Z_1$=50$\mu$m,$f_{r2}$=500kHz, $D_{f,max}$=4.6kHz, $D_{f,min}$=-4.6kHz. According to a third example, $f_{r1}$=25kHz, $Z_1$=10$\mu$m, $f_{r2}$=500kHz, $D_{f,max}$=2. 3kHz, $D_{f,min}$=-2. 3kHz. According to a fourth example, $f_{r1}$=25kHz, $Z_1$=50$\mu$m,$f_{r2}$=500kHz, $D_{f,max}$=11.8kHz, $D_{f,min}$=-11.3kHz. According to a fifth example, $f_{r1}$=25kHz, $Z_1$=50$\mu$m, $f_{r2}$=1MHz, $D_{f,max}$=23.6kHz, $D_{f,min}$=-22.6kHz. According to a sixth example, $f_{r1}$=5kHz, $Z_1$=50$\mu$m,$f_{r2}$=1MHz, $D_{f,max}$=4.6kHz, $D_{f,min}$=-4.6kHz. Furthermore, the oscillation amplitude $Z_2$ of the transduction membrane 83 (i.e. double the maximum value of the displacement of the transduction membrane 83 along the Z axis with respect to its rest position) is for example equal to about a few nanometres or tens of nanometres, for example, is equal to about 10 nm.

Since the acoustic wave frequency $f_o$ depends on the emission direction of the acoustic waves, the MUT device 50 allows performing selective measurements at predetermined tilting angles $\theta$ and therefore allows discriminating between multiple objects O present in the field-of-view, FOV, of the MUT device 50. This allows not having necessarily the measurement of the object present in the FOV and closer to the MUT device 50, but rather being capable of discriminating between different emission directions and therefore being capable of measuring the distance even of objects O that are not the closer to the MUT device 50.

For example, Figure 15 shows the MUT device 50 with its FOV 96 defined by a first tilting angle range (i.e. defined by $e_{min} \leq \theta \leq \theta_{max}$). A first and a second object $O_1$ and $O_2$ are present in the FOV 96 at different tilting angles $\theta$ (i.e. they have different emission directions), where the second object $O_2$ is closer to the MUT device 50 than the first object $O_1$. By being capable of discriminating the tilting angle $\theta$, the MUT device may also measure the distance of the first object $O_1$ and not

only of the second object $O_2$. This occurs by generating the emitted waves $W_e$ only in a second tilting angle range smaller than the first tilting angle range (emission mode), or by considering only the reflected waves $W_r$ in this second tilting angle range (reception mode).

Finally, it is clear that modifications and variations may be made to the invention described and illustrated herein without thereby departing from the scope of the present invention, as defined in the attached claims. For example, the different embodiments described may be combined with each other to provide further solutions.

Furthermore, the MUT device 50 may comprise a plurality of MUT elements 55 mutually arranged side by side, for example aligned on rows and columns in top view. For example, and in a manner not shown, each MUT element 55 is connected independently, through electrical connections and contact pads, to a control unit (generally provided in a different die, for example provided as an ASIC, "Application Specific Integrated Circuit"). Alternatively, the MUT elements 55 may be connected to groups, wherein the MUT elements 55 of a group are controlled separately and the groups are controllable separately, to reduce the number and simplify the electrical connections.

**Claims**

1. A MEMS ultrasonic transducer, MUT, device (50), comprising a semiconductor body (53) of semiconductor material which defines a support structure (53'), has a first (53A) and a second (53B) main face opposite to each other along a first axis (Z) and integrates at least one MUT element (55) including:

   - a modulation cavity (65) which extends into the semiconductor body (53) from the second main face (53B) towards the first main face (53A);
   - a membrane body (67) of the semiconductor body (53), which extends along the first axis (Z) between the modulation cavity (65) and the first main face (53A) and which is fixed to the support structure (53') so as to be suspended on the modulation cavity (65), the membrane body (67) comprising a central portion (67') and one or more extremal portions (67") which are interposed, orthogonally to the first axis (Z), between the central portion (67') and the support structure (53') and which mutually couple the central portion (67') and the support structure (53'), the central portion (67') defining at least one transduction membrane body (78) and the one or more extremal portions (67") defining a modulation membrane body (68);
   - a piezoelectric modulation structure (69) which extends on the modulation membrane body (68), on the first main face (53A), and forms, with the modulation membrane body (68), a modulation membrane (73) of the MUT element (55), suspended on the modulation cavity (65);
   - at least one transduction cavity (75) which extends into the central portion (67') of the membrane body (67), the transduction membrane body (78) extending along the first axis (Z) between the transduction cavity (75) and the first main face (53A); and
   - a piezoelectric transduction structure (79) which extends on the transduction membrane body (78), on the first main face (53A), and forms, with the transduction membrane body (78), a transduction membrane (83) of the MUT element (55), suspended on the transduction cavity (75),

   wherein the modulation membrane body (68) has a first thickness ($S_1$) along the first axis (Z), and the transduction membrane body (78) has, along the first axis (Z), a second thickness ($S_2$) smaller than the first thickness ($S_1$),
   wherein the piezoelectric modulation structure (69) is electrically controllable to vibrate the modulation membrane (73) at a first vibration frequency and the piezoelectric transduction structure (79) is configured to generate and/or detect the vibration of the transduction membrane (83) at a second vibration frequency higher than the first vibration frequency, in order to emit and/or receive, by the transduction membrane (83), acoustic waves at a frequency ($f_o$) which depends on the first vibration frequency and on the second vibration frequency.

2. The MUT device according to claim 1, wherein the first thickness ($S_1$) is a minimum thickness of the modulation membrane body (68) along the first axis (Z) and the second thickness ($S_2$) is a maximum thickness of the transduction membrane body (78) along the first axis (Z).

3. The MUT device according to claim 1 or 2, wherein the transduction cavity (75) is of the buried type, or wherein the transduction cavity (75) is of the exposed type and faces the modulation cavity (65).

4. The MUT device according to any of the preceding claims, wherein the piezoelectric transduction structure (79) is superimposed, along the first axis (Z), on the transduction cavity (75) and the piezoelectric modulation structure (69) is staggered, along the first axis (Z), with respect to the transduction cavity (75), the piezoelectric transduction structure (79) and the piezoelectric modulation structure (69) being arranged side by side to each other orthogonally to the first axis (Z).

5. The MUT device according to any of the preceding claims, wherein the MUT element (55) has axial symmetry along a central axis (77) parallel to, or coinciding with, the first axis (Z).

6. The MUT device according to claim 5, wherein the modulation membrane body (68) and the transduction membrane body (78) are concentric and coaxial along the central axis (77), the modulation membrane body (68) being radially external to the transduction membrane body (78) with respect to the central axis (77).

7. The MUT device according to any of the preceding claims, wherein the central portion (67') defines a plurality of said transduction membrane bodies (78) arranged side by side to each other orthogonally to the first axis (Z), and

wherein the MUT element (55) comprises:

- a respective plurality of said transduction cavities (75) which extend into the central portion (67') of the membrane body (67), arranged side by side to each other orthogonally to the first axis (Z), each transduction membrane body (78) extending along the first axis (Z) between the respective transduction cavity (75) and the first main face (53A); and
- a respective plurality of said piezoelectric transduction structures (79) arranged side by side to each other orthogonally to the first axis (Z), each extending on the respective transduction membrane body (78), on the first main face (53A), and forming with the respective transduction membrane body (78) a respective transduction membrane (83) of the MUT element (55), suspended on the respective transduction cavity (75),

wherein each transduction membrane body (78) has the second thickness ($S_2$) along the first axis (Z).

8. A process of manufacturing a MEMS ultrasonic transducer, MUT, device (50), comprising the step of forming at least one MUT element (55) in a semiconductor body (53) of semiconductor material, the semiconductor body (53) defining a support structure (53') and having a first (53A) and a second (53B) main face opposite to each other along a first axis (Z),

wherein the step of forming the at least one MUT element (55) comprises:

- forming a modulation cavity (65) in the semiconductor body (53), from the second main face (53B) towards the first main face (53A), thus defining a membrane body (67) of the semiconductor body (53), which extends along the first axis (Z) between the modulation cavity (65) and the first main face (53A) and which is fixed to the support structure (53') so as to be suspended on the modulation cavity (65), the membrane body (67) comprising a central portion (67') and one or more extremal portions (67") which are interposed, orthogonally to the first axis (Z), between the central portion (67') and the support structure (53') and which mutually couple the central portion (67') and the support structure (53'), the one or more extremal portions (67") defining a modulation membrane body (68);
- forming at least one transduction cavity (75) in the central portion (67') of the membrane body (67), thus defining at least one transduction membrane body (78) of the central portion (67'), the transduction membrane body (78) extending along the first axis (Z) between the transduction cavity (75) and the first main face (53A);
- forming, on the first main face (53A), a piezoelectric modulation structure (69) on the modulation membrane body (68) and a piezoelectric transduction structure (79) on the transduction membrane body (78), the piezoelectric modulation structure (69) forming with the modulation membrane body (68) a modulation membrane (73) of the MUT element (55), suspended on the modulation cavity (65) and the piezoelectric transduction structure (79) forming with the transduction membrane body (78) a transduction membrane (83) of the MUT element (55), suspended on the transduction cavity (75),

wherein the modulation membrane body (68) has a first thickness ($S_1$) along the first axis (Z) and the transduction membrane body (78) has a second thickness ($S_2$) smaller than the first thickness ($S_1$) along the first axis (Z), wherein the piezoelectric modulation structure (69) is electrically controllable to vibrate the modulation membrane (73) at a first vibration frequency and the piezoelectric transduction structure (79) is configured to generate and/or detect the vibration of the transduction membrane (83) at a second vibration frequency higher than the first vibration frequency, in order to emit and/or receive, by the transduction membrane (83), acoustic waves at a frequency ($f_o$) which depends on the first vibration frequency and the second vibration frequency.

9. The manufacturing process according to claim 8, wherein the step of forming the transduction cavity (75) comprises:

- forming, in a substrate (100) of semiconductor material, a plurality of trenches (102) mutually separated by pillar structures (103);
- performing an epitaxial growth in a reducing environment so as to form a first superficial layer of semiconductor material, closing the trenches (102) upwardly; and
- carrying out an annealing such as to cause a migration of atoms of semiconductor material of the pillar structures (103), thus forming the transduction cavity (75) of the buried type and the transduction membrane body (78) closing the transduction cavity (75) upwardly.

10. The manufacturing process according to claim 9, wherein the step of forming the piezoelectric modulation structure (69) and the piezoelectric transduction structure (79) is performed after forming the transduction cavity (75), and wherein the step of forming the modulation cavity (65) is performed after forming the piezoelectric modulation structure (69) and the piezoelectric transduction structure (79) and comprises performing a first deep etch of the silicon from the second main face (53B) of the semiconductor body (53).

11. The manufacturing process according to claim 8, wherein the step of forming the modulation cavity (65) is performed after forming the piezoelectric modulation structure (69) and the piezoelectric transduction structure (79) on the first main face (53A) of the semiconductor body (53) and comprises performing a first deep etch of the silicon from the second main face (53B) of the semiconductor body (53), at a first region of the semiconductor body (53) aligned, along the first axis (Z), with the piezoelectric modulation structure (69) and the piezoelectric transduction structure (79), the modulation cavity (65) being delimited upwardly by a first bottom surface (65A) of the semiconductor body (53), and wherein the step of forming the transduction cavity (79) is performed after forming the modulation cavity (65) and comprises performing a second deep etch of the silicon from the first bottom surface (65A) of the semiconductor body (53), at a second region of the semiconductor body (53) aligned, along the first axis (Z), with the piezoelectric transduction structure (79).

12. A method of controlling a MEMS ultrasonic transducer, MUT, device (50), according to any of claims 1-7, the control method comprising the steps of:

- electrically controlling the piezoelectric modulation structure (69) to vibrate the modulation membrane (73) at the first vibration frequency; and
- in an emission mode of the MUT device (50), electrically controlling the piezoelectric transduction structure (79) so as to vibrate the transduction membrane (83) at the second vibration frequency to generate said acoustic waves or, in a reception mode of the MUT device (50), detecting, through the piezoelectric transduction structure (79), the vibration of the transduction membrane (83) at the second vibration frequency, induced by said acoustic waves impinging on the MUT device (50).

13. The control method according to claim 12, wherein the step of electrically controlling the piezoelectric transduction structure (79) in the emission mode of the MUT device (50) and the step of detecting the vibration of the transduction membrane (83) in the reception mode of the MUT device (50) are performed in one or more time intervals (T*) wherein the modulation membrane (73) moves linearly along the first axis (Z), relative to a rest position thereof.

**Patentansprüche**

1. MEMS-Ultraschallwandler, MUT,-Vorrichtung (50), die einen Halbleiterkörper (53) aus Halbleitermaterial umfasst, der eine Trägerstruktur (53') definiert, eine erste (53A) und eine zweite (53B) Hauptfläche aufweist, die einander entlang einer ersten Achse (Z) gegenüberliegen, und mindestens ein MUT-Element (55) integriert, das Folgendes enthält:

- einen Modulationshohlraum (65), der sich von der zweiten Hauptfläche (53B) in Richtung der ersten Hauptfläche (53A) in den Halbleiterkörper (53) erstreckt;
- einen Membrankörper (67) des Halbleiterkörpers (53), der sich entlang der ersten Achse (Z) zwischen dem Modulationshohlraum (65) und der ersten Hauptfläche (53A) erstreckt und so an der Trägerstruktur (53') befestigt ist, dass er an dem Modulationshohlraum (65) aufgehängt ist, wobei der Membrankörper (67) einen zentralen Abschnitt (67') und einen oder mehrere extremale Abschnitte (67") umfasst, die orthogonal zur ersten Achse (Z) zwischen dem zentralen Abschnitt (67') und der Trägerstruktur (53') eingefügt sind und den zentralen Abschnitt (67') und die Trägerstruktur (53') miteinander koppeln, wobei der zentrale Abschnitt (67') mindestens einen Transduktionsmembrankörper (78) definiert und der eine oder die mehreren extremalen Abschnitte (67") einen Modulationsmembrankörper (68) definieren;
- eine piezoelektrische Modulationsstruktur (69), die sich auf der ersten Hauptfläche (53A) auf dem Modulationsmembrankörper (68) erstreckt und mit dem Modulationsmembrankörper (68) eine Modulationsmembran (73) des MUT-Elements (55) bildet, die an dem Modulationshohlraum (65) aufgehängt ist;
- mindestens einen Transduktionshohlraum (75), der sich in den zentralen Abschnitt (67') des Membrankörpers (67) erstreckt, wobei der Transduktionsmembrankörper (78) sich entlang der ersten Achse (Z) zwischen dem Transduktionshohlraum (75) und der ersten Hauptfläche (53A) erstreckt; und
- eine piezoelektrische Transduktionsstruktur (79), die sich auf der ersten Hauptfläche (53A) auf dem Transduktionsmembrankörper (78) erstreckt und mit dem Transduktionskörper (78) eine Transduktionsmembran (83) des MUT-Elements (55) bildet, die an dem Transduktionshohlraum (75) aufgehängt ist,

wobei der Modulationsmembrankörper (68) eine erste Dicke ($S_1$) entlang der ersten Achse (Z) aufweist und der Transduktionsmembrankörper (78) entlang der ersten Achse (Z) eine zweite Dicke ($S_2$) aufweist, die kleiner als die erste Dicke ($S_1$) ist,
wobei die piezoelektrische Modulationsstruktur (69) elektrisch steuerbar ist, um die Modulationsmembran (73) mit einer ersten Schwingungsfrequenz zum Schwingen zu bringen, und die piezoelektrische Transduktionsstruktur (79) dazu konfiguriert ist, die Schwingung der Transduktionsmembran (83) mit einer zweiten Schwingungsfrequenz, die höher als die erste Schwingungsfrequenz ist, zu erzeugen und/oder zu detektieren, um durch die Transduktionsmembran (83) akustische Wellen mit einer Frequenz ($f_o$), die von der ersten Schwingungsfrequenz und von der zweiten Schwingungsfrequenz abhängt, zu emittieren und/oder zu empfangen.

2.  MUT-Vorrichtung nach Anspruch 1, wobei die erste Dicke ($S_1$) eine minimale Dicke des Modulationsmembrankörpers (68) entlang der ersten Achse (Z) ist und die zweite Dicke ($S_2$) eine maximale Dicke des Transduktionsmembrankörpers (78) entlang der ersten Achse (Z) ist.

3.  MUT-Vorrichtung nach Anspruch 1 oder 2, wobei der Transduktionshohlraum (75) vom vergrabenen Typ ist, oder wobei der Transduktionshohlraum (75) vom freiliegenden Typ ist und dem Modulationshohlraum (65) zugewandt ist.

4.  MUT-Vorrichtung nach einem der vorhergehenden Ansprüche, wobei die piezoelektrische Transduktionsstruktur (79) entlang der ersten Achse (Z) dem Transduktionshohlraum (75) überlagert ist und die piezoelektrische Modulationsstruktur (69) im Bezug auf den Transduktionshohlraum (75) entlang der ersten Achse (Z) versetzt ist, wobei die piezoelektrische Transduktionsstruktur (79) und die piezoelektrische Modulationsstruktur (69) orthogonal zur ersten Achse (Z) nebeneinander angeordnet sind.

5.  MUT-Vorrichtung nach einem der vorhergehenden Ansprüche, wobei das MUT-Element (55) eine axiale Symmetrie entlang einer zentralen Achse (77) aufweist, die parallel zur ersten Achse (Z) verläuft oder mit dieser zusammenfällt.

6.  MUT-Vorrichtung nach Anspruch 5, wobei der Modulationsmembrankörper (68) und der Transduktionsmembrankörper (78) konzentrisch sind und koaxial entlang der zentralen Achse (77) liegen, wobei der Modulationsmembrankörper (68) in Bezug auf die zentrale Achse (77) radial außerhalb des Transduktionsmembrankörpers (78) liegt.

7.  MUT-Vorrichtung nach einem der vorhergehenden Ansprüche, wobei der zentrale Abschnitt (67') eine Vielzahl der Transduktionsmembrankörper (78) definiert, die orthogonal zur ersten Achse (Z) nebeneinander angeordnet sind, und wobei das MUT-Element (55) Folgendes umfasst:

- eine jeweilige Vielzahl der Transduktionshohlräume (75), die sich in den zentralen Abschnitt (67') des Membrankörpers (67) erstrecken und orthogonal zur ersten Achse (Z) nebeneinander angeordnet sind, wobei sich jeder Transduktionsmembrankörper (78) entlang der ersten Achse (Z) zwischen dem jeweiligen Transduktionshohlraum (75) und der ersten Hauptfläche (53A) erstreckt; und
- eine jeweilige Vielzahl der piezoelektrischen Transduktionsstrukturen (79), die orthogonal zur ersten Achse (Z) nebeneinander angeordnet sind, sich jeweils auf der ersten Hauptfläche (53A) auf dem jeweiligen Transduktionsmembrankörper (78) erstrecken und mit dem jeweiligen Transduktionsmembrankörper (78) eine jeweilige Transduktionsmembran (83) des MUT-Elements (55) bilden, die an dem jeweiligen Transduktionshohlraum (75) aufgehängt ist,

wobei jeder Transduktionsmembrankörper (78) die zweite Dicke ($S_2$) entlang der ersten Achse (Z) aufweist.

8. Verfahren zum Herstellen einer MEMS-Ultraschallwandler, MUT,-Vorrichtung (50), das den Schritt des Bilden mindestens eines MUT-Elements (55) in einem Halbleiterkörper (53) aus Halbleitermaterial umfasst, wobei der Halbleiterkörper (53) eine Trägerstruktur (53') definiert und eine erste (53A) und eine zweite (53B) Hauptfläche aufweist, die einander entlang einer ersten Achse (Z) gegenüberliegen,

wobei der Schritt des Bildens des mindestens einen MUT-Elements (55) Folgendes umfasst:

- Bilden eines Modulationshohlraums (65) in dem Halbleiterkörper (53) von der zweiten Hauptfläche (53B) in Richtung der ersten Hauptfläche (53A), wodurch ein Membrankörper (67) des Halbleiterkörpers (53) definiert wird, der sich entlang der ersten Achse (Z) zwischen dem Modulationshohlraum (65) und der ersten Hauptfläche (53A) erstreckt und so an der Trägerstruktur (53') befestigt ist, dass er an dem Modulationshohlraum (65) aufgehängt ist, wobei der Membrankörper (67) einen zentralen Abschnitt (67') und einen oder mehrere extremale Abschnitte (67") umfasst, die orthogonal zur ersten Achse (Z) zwischen dem zentralen Abschnitt (67') und der Trägerstruktur (53') eingefügt sind und den zentralen Abschnitt (67') und die Trägerstruktur (53') miteinander koppeln, wobei der eine oder die mehreren extremalen Abschnitte (67") einen Modulationsmembrankörper (68) definieren;
- Bilden mindestens eines Transduktionshohlraums (75) in dem zentralen Abschnitt (67') des Membrankörpers (67), wodurch mindestens ein Transduktionsmembrankörper (78) des zentralen Abschnitts (67') definiert wird, wobei der Transduktionsmembrankörper (78) sich entlang der ersten Achse (Z) zwischen dem Transduktionshohlraum (75) und der ersten Hauptfläche (53A) erstreckt;
- Bilden einer piezoelektrischen Modulationsstruktur (69) auf dem Modulationsmembrankörper (68) auf der ersten Hauptfläche (53A) und einer piezoelektrischen Transduktionsstruktur (79) auf dem Transduktionsmembrankörper (78), wobei die piezoelektrische Modulationsstruktur (69) mit dem Modulationsmembrankörper (68) eine Modulationsmembran (73) des MUT-Elements (55) bildet, die an dem Modulationshohlraum (65) aufgehängt ist, und die piezoelektrische Transduktionsstruktur (79) mit dem Transduktionsmembrankörper (78) eine Transduktionsmembran (83) des MUT-Elements (55) bildet, die an dem Transduktionshohlraum (75) aufgehängt ist,

wobei der Modulationsmembrankörper (68) eine erste Dicke ($S_1$) entlang der ersten Achse (Z) aufweist und der Transduktionsmembrankörper (78) eine zweite Dicke ($S_2$), die kleiner als die erste Dicke ($S_1$) ist, entlang der ersten Achse (Z) aufweist, wobei die piezoelektrische Modulationsstruktur (69) elektrisch steuerbar ist, um die Modulationsmembran (73) mit einer ersten Schwingungsfrequenz zum Schwingen zu bringen, und die piezoelektrische Transduktionsstruktur (79) dazu konfiguriert ist, die Schwingung der Transduktionsmembran (83) mit einer zweiten Schwingungsfrequenz, die höher als die erste Schwingungsfrequenz ist, zu erzeugen und/oder zu detektieren, um durch die Transduktionsmembran (83) akustische Wellen mit einer Frequenz ($f_o$), die von der ersten Schwingungsfrequenz und von der zweiten Schwingungsfrequenz abhängt, zu emittieren und/oder zu empfangen.

9. Herstellungsverfahren nach Anspruch 8, wobei der Schritt des Bildens des Transduktionshohlraums (75) Folgendes umfasst:

- Bilden einer Vielzahl von Gräben (102), die durch Säulenstrukturen (103) voneinander getrennt sind, in einem Substrat (100) aus Halbleitermaterial;
- Durchführen eines epitaktischen Wachstums in einer reduzierenden Umgebung, um eine erste Oberflächenschicht aus Halbleitermaterial zu bilden, wobei die Gräben (102) nach oben geschlossen werden; und
- Ausführen einer Wärmebehandlung, derart, dass eine Wanderung der Atome des Halbleitermaterials der Säulenstrukturen (103) bewirkt wird, wodurch der Transduktionshohlraum (75) vom vergrabenen Typ gebildet wird und der Transduktionsmembrankörper (78) den Transduktionshohlraum (75) nach oben hin verschließt.

10. Herstellungsverfahren nach Anspruch 9, wobei der Schritt des Bildens der piezoelektrischen Modulationsstruktur (69) und der piezoelektrischen Transduktionsstruktur (79) nach dem Bilden des Transduktionshohlraums (75) durchgeführt wird, und
wobei der Schritt des Bildens des Modulationshohlraums (65) nach dem Bilden der piezoelektrischen Modulationsstruktur (69) und der piezoelektrischen Transduktionsstruktur (79) durchführt wird und das Durchführen eines ersten tiefen Ätzens des Siliziums von der zweiten Hauptfläche (53B) des Halbleiterkörpers (53) umfasst.

11. Herstellungsverfahren nach Anspruch 8, wobei der Schritt des Bildens des Modulationshohlraums (65) nach dem Bilden der piezoelektrischen Modulationsstruktur (69) und der piezoelektrischen Transduktionsstruktur (79) auf der ersten Hauptfläche (53A) des Halbleiterkörpers (53) durchgeführt wird und das Durchführen eines ersten tiefen Ätzens des Siliziums von der zweiten Hauptfläche (53B) des Halbleiterkörpers (53) in einem ersten Bereich des Halbleiterkörpers (53) umfasst, der entlang der ersten Achse (Z) mit der piezoelektrischen Modulationsstruktur (69) und der piezoelektrischen Transduktionsstruktur (79) ausgerichtet ist, wobei der Modulationshohlraum (65) nach oben durch eine erste Bodenfläche (65A) des Halbleiterkörpers (53) begrenzt ist, und
wobei der Schritt des Bildens des Transduktionshohlraums (79) nach dem Bilden des Modulationshohlraums (65) durchgeführt wird und das Durchführen eines zweiten tiefen Ätzens des Siliziums von der ersten Bodenfläche (65A) des Halbleiterkörpers (53) in einem zweiten Bereich des Halbleiterkörpers (53) umfasst, der entlang der ersten Achse (Z) mit der piezoelektrischen Transduktionsstruktur (79) ausgerichtet ist.

12. Verfahren zum Steuern einer MEMS-Ultraschallwandler, MUT,-Vorrichtung (50) nach einem der Ansprüche 1-7, wobei das Steuerverfahren die folgenden Schritte umfasst:

- elektrisches Steuern der piezoelektrischen Modulationsstruktur (69), um die Modulationsmembran (73) mit der ersten Schwingungsfrequenz zum Schwingen zu bringen; und
- in einem Emissionsmodus der MUT-Vorrichtung (50), elektrisches Steuern der piezoelektrischen Transduktionsstruktur (79), um die Transduktionsmembran (83) mit der zweiten Schwingungsfrequenz zum Schwingen zu bringen, um die akustischen Wellen zu erzeugen, oder in einem Empfangsmodus der MUT-Vorrichtung (50), Detektieren der Schwingung der Transduktionsmembran (83) mit der zweiten Schwingungsfrequenz, die durch die auf die MUT-Vorrichtung (50) auftreffenden akustischen Wellen induziert wird, durch die piezoelektrische Transduktionsstruktur (79).

13. Steuerverfahren nach Anspruch 12, wobei der Schritt des elektrischen Steuerns der piezoelektrischen Transduktionsstruktur (79) im Emissionsmodus der MUT-Vorrichtung (50) und der Schritt des Detektierens der Schwingung der Transduktionsmembran (83) im Empfangsmodus der MUT-Vorrichtung (50) in einem oder mehreren Zeitintervallen (T*) durchgeführt werden,
wobei sich die Modulationsmembran (73) im Verhältnis zu ihrer Ruheposition linear entlang der ersten Achse (Z) bewegt.

## Revendications

1. Dispositif transducteur ultrasonore MEMS, MUT (50), comprenant un corps semi-conducteur (53) d'un matériau semi-conducteur qui définit une structure de support (53'), a une première face principale (53A) et une seconde face principale (53B) opposées l'une à l'autre le long d'un premier axe (Z) et intègre au moins un élément MUT (55) comportant :

- une cavité de modulation (65) qui s'étend dans le corps semi-conducteur (53) depuis la seconde face principale (53B) vers la première face principale (53A) ;
- un corps de membrane (67) du corps semi-conducteur (53), qui s'étend le long du premier axe (Z) entre la cavité de modulation (65) et la première face principale (53A) et qui est fixé à la structure de support (53') de manière à être suspendu sur la cavité de modulation (65), le corps de membrane (67) comprenant une partie centrale (67') et une ou plusieurs parties extrémales (67") qui sont interposées, orthogonalement au premier axe (Z), entre la partie centrale (67') et la structure de support (53') et qui accouplent mutuellement la partie centrale (67') et la structure de support (53'), la partie centrale (67') définissant au moins un corps de membrane de transduction (78) et les une ou plusieurs parties extrémales (67") définissant un corps de membrane de modulation (68) ;
- une structure de modulation piézoélectrique (69) qui s'étend sur le corps de membrane de modulation (68), sur la première face principale (53A), et forme, avec le corps de membrane de modulation (68), une membrane de modulation (73) de l'élément MUT (55), suspendue sur la cavité de modulation (65) ;
- au moins une cavité de transduction (75) qui s'étend dans la partie centrale (67') du corps de membrane (67), le corps de membrane de transduction (78) s'étendant le long du premier axe (Z) entre la cavité de transduction (75) et la première face principale (53A) ; et
- une structure de transduction piézoélectrique (79) qui s'étend sur le corps de membrane de transduction (78), sur la première face principale (53A), et forme, avec le corps de membrane de transduction (78), une membrane de transduction (83) de l'élément MUT (55), suspendue sur la cavité de transduction (75),

dans lequel le corps de membrane de modulation (68) a une première épaisseur ($S_1$) le long du premier axe (Z), et le corps de membrane de transduction (78) a, le long du premier axe (Z), une seconde épaisseur ($S_2$) inférieure à la première épaisseur ($S_1$),
dans lequel la structure de modulation piézoélectrique (69) peut être commandée électriquement pour faire vibrer la membrane de modulation (73) à une première fréquence de vibration et la structure de transduction piézoélectrique (79) est configurée pour générer et/ou détecter la vibration de la membrane de transduction (83) à une seconde fréquence de vibration supérieure à la première fréquence de vibration, afin d'émettre et/ou de recevoir, au moyen de la membrane de transduction (83), des ondes acoustiques à une fréquence ($f_o$) qui dépend de la première fréquence de vibration et de la seconde fréquence de vibration.

**2.** Dispositif MUT selon la revendication 1, dans lequel la première épaisseur ($S_1$) est une épaisseur minimale du corps de membrane de modulation (68) le long du premier axe (Z) et la seconde épaisseur ($S_2$) est une épaisseur maximale du corps de membrane de transduction (78) le long du premier axe (Z).

**3.** Dispositif MUT selon la revendication 1 ou 2, dans lequel la cavité de transduction (75) est du type enfoui, ou dans lequel la cavité de transduction (75) est du type exposé et fait face à la cavité de modulation (65).

**4.** Dispositif MUT selon l'une quelconque des revendications précédentes, dans lequel la structure de transduction piézoélectrique (79) est superposée, le long du premier axe (Z), à la cavité de transduction (75), et la structure de modulation piézoélectrique (69) est échelonnée, le long du premier axe (Z), par rapport à la cavité de transduction (75), la structure de transduction piézoélectrique (79) et la structure de modulation piézoélectrique (69) étant agencées côte à côte orthogonalement au premier axe (Z).

**5.** Dispositif MUT selon l'une quelconque des revendications précédentes, dans lequel l'élément MUT (55) a une symétrie axiale le long d'un axe central (77) parallèle à, ou coïncidant avec, le premier axe (Z).

**6.** Dispositif MUT selon la revendication 5, dans lequel le corps de membrane de modulation (68) et le corps de membrane de transduction (78) sont concentriques et coaxiaux le long de l'axe central (77), le corps de membrane de modulation (68) étant radialement externe au corps de membrane de transduction (78) par rapport à l'axe central (77).

**7.** Dispositif MUT selon l'une quelconque des revendications précédentes, dans lequel la partie centrale (67') définit une pluralité desdits corps de membrane de transduction (78) agencés côte à côte orthogonalement au premier axe (Z), et dans lequel l'élément MUT (55) comprend :

- une pluralité respective desdites cavités de transduction (75) qui s'étendent dans la partie centrale (67') du corps de membrane (67), agencées côte à côte orthogonalement au premier axe (Z), chaque corps de membrane de transduction (78) s'étendant le long du premier axe (Z) entre la cavité de transduction (75) respective et la première face principale (53A) ; et
- une pluralité respective desdites structures de transduction piézoélectriques (79) agencées côte à côte orthogonalement au premier axe (Z), chacune s'étendant sur le corps de membrane de transduction (78) respectif, sur la première face principale (53A), et formant avec le corps de membrane de transduction (78) respectif une membrane de transduction (83) respective de l'élément MUT (55), suspendue sur la cavité de transduction (75) respective, dans lequel chaque corps de membrane de transduction (78) a la seconde épaisseur ($S_2$) le long du premier axe (Z).

**8.** Procédé de fabrication d'un dispositif transducteur ultrasonore MEMS, MUT (50), comprenant l'étape consistant à former au moins un élément MUT (55) dans un corps semi-conducteur (53) d'un matériau semi-conducteur, le corps semi-conducteur (53) définissant une structure de support (53') et ayant une première face principale (53A) et une seconde face principale (53B) opposées l'une à l'autre le long d'un premier axe (Z),

dans lequel l'étape consistant à former l'au moins un élément MUT (55) comprend :

- la formation d'une cavité de modulation (65) dans le corps semi-conducteur (53), depuis la seconde face principale (53B) vers la première face principale (53A), définissant ainsi un corps de membrane (67) du corps semi-conducteur (53), qui s'étend le long du premier axe (Z) entre la cavité de modulation (65) et la première face principale (53A) et qui est fixé à la structure de support (53') de manière à être suspendu sur la cavité de modulation (65), le corps de membrane (67) comprenant une partie centrale (67') et une ou plusieurs parties extrémales (67") qui sont interposées, orthogonalement au premier axe (Z), entre la partie centrale (67') et la structure de support (53') et qui accouplent mutuellement la partie centrale (67') et la structure de support (53'), les une ou plusieurs parties extrémales (67") définissant un corps de membrane de modulation (68) ;
- la formation d'au moins une cavité de transduction (75) dans la partie centrale (67') du corps de membrane (67), définissant ainsi au moins un corps de membrane de transduction (78) de la partie centrale (67'), le corps de membrane de transduction (78) s'étendant le long du premier axe (Z) entre la cavité de transduction (75) et la première face principale (53A) ;
- la formation, sur la première face principale (53A), d'une structure de modulation piézoélectrique (69) sur le corps de membrane de modulation (68) et d'une structure de transduction piézoélectrique (79) sur le corps de membrane de transduction (78), la structure de modulation piézoélectrique (69) formant avec le corps de membrane de modulation (68) une membrane de modulation (73) de l'élément MUT (55), suspendue sur la cavité de modulation (65) et la structure de transduction piézoélectrique (79) formant avec le corps de membrane de transduction (78) une membrane de transduction (83) de l'élément MUT (55), suspendue sur la cavité de transduction (75),

dans lequel le corps de membrane de modulation (68) a une première épaisseur ($S_1$) le long du premier axe (Z) et le corps de membrane de transduction (78) a une seconde épaisseur ($S_2$) inférieure à la première épaisseur ($S_1$) le long du premier axe (Z),
dans lequel la structure de modulation piézoélectrique (69) peut être commandée électriquement pour faire vibrer la membrane de modulation (73) à une première fréquence de vibration et la structure de transduction piézoélectrique (79) est configurée pour générer et/ou détecter la vibration de la membrane de transduction (83) à une seconde fréquence de vibration supérieure à la première fréquence de vibration, afin d'émettre et/ou de recevoir, au moyen de la membrane de transduction (83), des ondes acoustiques à une fréquence ($f_o$) qui dépend de la première fréquence de vibration et de la seconde fréquence de vibration.

9. Procédé de fabrication selon la revendication 8, dans lequel l'étape consistant à former la cavité de transduction (75) comprend :

- la formation, dans un substrat (100) d'un matériau semi-conducteur, d'une pluralité de tranchées (102) mutuellement séparées par des structures de colonnes (103) ;
- la réalisation d'une croissance épitaxiale dans un milieu réducteur de manière à former une première couche superficielle d'un matériau semi-conducteur, fermant les tranchées (102) vers le haut ; et
- l'exécution d'un recuit de façon à entraîner une migration d'atomes d'un matériau semi-conducteur des structures de colonnes (103), formant ainsi la cavité de transduction (75) du type enfoui et le corps de membrane de transduction (78) fermant la cavité de transduction (75) vers le haut.

10. Procédé de fabrication selon la revendication 9, dans lequel l'étape consistant à former la structure de modulation piézoélectrique (69) et la structure de transduction piézoélectrique (79) est réalisée après la formation de la cavité de transduction (75), et
dans lequel l'étape consistant à former la cavité de modulation (65) est réalisée après la formation de la structure de modulation piézoélectrique (69) et de la structure de transduction piézoélectrique (79) et comprend la réalisation d'une première gravure profonde du silicium à partir de la seconde face principale (53B) du corps semi-conducteur (53).

11. Procédé de fabrication selon la revendication 8, dans lequel l'étape consistant à former la cavité de modulation (65) est réalisée après la formation de la structure de modulation piézoélectrique (69) et de la structure de transduction piézoélectrique (79) sur la première face principale (53A) du corps semi-conducteur (53) et comprend la réalisation d'une première gravure profonde du silicium à partir de la seconde face principale (53B) du corps semi-conducteur (53), au niveau d'une première région du corps semi-conducteur (53) alignée, le long du premier axe (Z), sur la structure de modulation piézoélectrique (69) et la structure de transduction piézoélectrique (79), la cavité de modulation (65) étant délimitée vers le haut par une première surface inférieure (65A) du corps semi-conducteur (53), et
dans lequel l'étape consistant à former la cavité de transduction (79) est réalisée après la formation de la cavité de modulation (65) et comprend la réalisation d'une seconde gravure profonde du silicium à partir de la première surface inférieure (65A) du corps semi-conducteur (53), au niveau d'une seconde région du corps semi-conducteur (53) alignée, le long du premier axe (Z), sur la structure de transduction piézoélectrique (79).

**12.** Procédé de commande d'un dispositif transducteur ultrasonore MEMS, MUT (50), selon l'une quelconque des revendications 1 à 7,

le procédé de commande comprenant les étapes consistant à :

- commander électriquement la structure de modulation piézoélectrique (69) pour faire vibrer la membrane de modulation (73) à la première fréquence de vibration ; et
- dans un mode d'émission du dispositif MUT (50), commander électriquement la structure de transduction piézoélectrique (79) de manière à faire vibrer la membrane de transduction (83) à la seconde fréquence de vibration pour générer lesdites ondes acoustiques ou, dans un mode de réception du dispositif MUT (50), détecter, à travers la structure de transduction piézoélectrique (79), la vibration de la membrane de transduction (83) à la seconde fréquence de vibration, induite par lesdites ondes acoustiques frappant sur le dispositif MUT (50).

**13.** Procédé de commande selon la revendication 12, dans lequel l'étape consistant à commander électriquement la structure de transduction piézoélectrique (79) dans le mode d'émission du dispositif MUT (50) et l'étape consistant à détecter la vibration de la membrane de transduction (83) dans le mode de réception du dispositif MUT (50) sont réalisées dans un ou plusieurs intervalles de temps (T*)

dans lequel la membrane de modulation (73) bouge linéairement le long du premier axe (Z), relativement à une position de repos de celle-ci.

FIG. 1

FIG. 2

FIG. 3

FIG. 15

EP 4 331 734 B1

FIG. 4

FIG. 5

EP 4 331 734 B1

FIG. 6

FIG. 7

24

FIG. 8

FIG. 9A

FIG. 9B

EP 4 331 734 B1

FIG. 9C

FIG. 9D

EP 4 331 734 B1

FIG. 9F

FIG. 9E

FIG. 10A

FIG. 10B

EP 4 331 734 B1

FIG. 11A

FIG. 11B

FIG. 12

FIG. 13A

FIG. 13B

EP 4 331 734 B1

FIG. 13C

FIG. 13D

EP 4 331 734 B1

FIG. 14A

FIG. 14B

FIG. 14C

FIG. 14D

EP 4 331 734 B1

35

**EP 4 331 734 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20130162102 A1
- US 20170095837 A1
- EP 1577656 A